# EUROPÄISCHE PATENTSCHRIFT

(11) **EP 2 768 625 B1**
(45) Veröffentlichungstag und Bekanntmachung des Hinweises auf die Patenterteilung: **07.06.2017**
(21) Anmeldenummer: 12778707.5
(22) Anmeldetag: 19.10.2012
(51) Int. Cl.: B23K 1/008, H05K 3/34

(54) **VORRICHTUNG UND VERFAHREN ZUM LÖTEN**
DEVICE AND METHOD FOR SOLDERING
DISPOSITIF ET PROCÉDÉ DE SOUDAGE

(30) Priorität: 21.10.2011 DE 202011107022 U
(43) Veröffentlichungstag der Anmeldung: 27.08.2014
(73) Patentinhaber: Asscon Systemtechnik-Elektronik GmbH, 86343 Königsbrunn (DE)
(72) Erfinder: ZABEL, Claus, 86199 Augsburg (DE)
(74) Vertreter: Wegner, Hans
(86) Internationale Anmeldenummer: PCT/EP2012/070759
(87) Internationale Veröffentlichungsnummer: WO 2013/057252

(56) Entgegenhaltungen:
- EP-A1- 1 968 108
- EP-A2- 1 350 588
- WO-A1-2007/088695
- DE-A1- 4 225 378
- DE-A1- 4 432 402
- DE-A1- 19 609 877
- US-A- 4 358 662
- US-A- 5 185 509
- US-A1- 2005 156 324
- US-A1- 2010 320 258

## Beschreibung

### 1. Technisches Gebiet

Die vorliegende Erfindung betrifft eine Vorrichtung zum Löten.

### 2. Stand der Technik

Lötprozesse spielen in vielen Bereichen der Industrie eine wichtige Rolle. Damit werden viele kleine einfache Bauteile, wie etwa Widerstände und große hochkomplexe Bauteile, beispielsweise Mikroprozessoren, auf Platinen verbunden. Durch die rasanten Fortschritte der Mikroelektronik werden immer komplexere Funktionen auf einem einzelnen Halbleiter-Chip realisiert. Durch die immer feiner werdenden Strukturen steigt zum einen die Leistungsfähigkeit hochintegrierter Halbleiter-Bauelemente stetig weiter an. Auf der anderen Seite wächst damit die aus den Bauelementen abzuführende Verlustleistung ebenfalls kontinuierlich. In vielen Fällen reicht deshalb die Wärmeabfuhr über die elektrischen Anschlussverbindungen nicht mehr aus. Vielmehr weisen diese teuren hochkomplexen Bauelemente direkt unterhalb des Halbleiter-Chips einen oder mehrere großflächige thermische Anschlüsse auf, die die Verlustleistung auf direktem Wege in die Leiterplatte und/oder einen Kühlkörper abführen.

Diese großflächigen thermischen Anschlussstellen stellen für die Löttechnik eine besondere Herausforderung dar. Zum einen ist ihre zuverlässige und gleichmäßige Erwärmung schwierig, da sie zwischen Bauelement und Leiterplatte eingeklemmt liegend der Einwirkung verschiedener Energieformen häufig schlecht zugänglich sind. Zum anderen passiert es sehr häufig, dass sich während des Lötprozesses Gaseinschlüsse innerhalb des großflächigen Lötkontakts bilden bzw. während des Lötprozesses in dem Lötanschluss verbleiben und nach dem Erstarren des Lotes Fehlstellen, sogenannte Lunker, in der Lötstelle bilden.

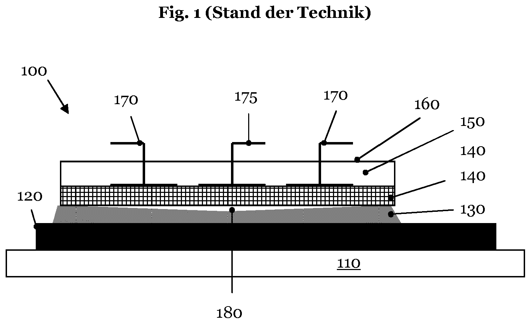

Die Ursache der Gaseinschlüsse kann vielfältig sein. Beispielsweise kann bei großflächigen Lötanschlüssen die Lotpaste nicht plan aufgebracht werden, so dass bereits beim Aufsetzen eines Bauelements auf das Lotmaterial Luft zwischen dem oder den Anschlusskontakt(en) und der Lotpaste eingeschlossen wird, die während des Lötprozesses nicht oder nur zum Teil entweichen kann. Die Fig. 1 zeigt schematisch die Situation nach dem Aufsetzen eines ganzflächig zu verlötenden Bauelements auf einen Lotpastenauftrag. Ferner können zum Beispiel lösliche Bestandteile des Lotmaterials, wie etwa Lösungsmittel- und/oder Flussmittelreste als Gaseinschlüsse oder Lunker beim Abkühlen des Lotes in der Lötverbindung eingeschlossen bleiben und somit Fehlstellen innerhalb des Lotmaterials bilden. Darüber hinaus entstehen während des Heizvorgangs durch die Reduktionswirkung des in dem Lotmaterial enthaltenen Flussmittels gasförmige Reaktionsprodukte, die das flüssige Lotmaterial häufig nicht oder zumindest nicht vollständig verlassen können und nach Abschluss des Lötvorgangs ebenfalls Fehlstellen in der Lötverbindung bilden. Die bei höheren Temperaturen schmelzenden bleifreien Lote weisen eine höhere Viskosität als die herkömmlichen bleihaltigen Lotmaterialien auf und verstärken dadurch die Tendenz zur Bildung von Lunkern wesentlich.

In den Bereichen der Gaseinschlüsse ist der thermische Widerstand zwischen Bauelement und Leiterplatte bzw. Kühlkörper sehr groß, so dass insgesamt der mittlere thermische Widerstand der Lötverbindung deutlich größer ist, wie bei der Auslegung des Bauelements simuliert bzw. angenommen. Dadurch kann die erwartete Lebensdauer des Halbleiter-Bauelements wesentlich verringert werden. Darüber hinaus können sich aufgrund der ungleichmäßigen Wärmeabfuhr in dem Chip lokale Überhitzungen, sogenannte hot spots, ergeben, die zu einem plötzlichen Ausfall der Funktion des Halbleiter-Bauelements führen können.

Im Bereich der Leistungselektronik - ein stark an Bedeutung gewinnender Bereich der Elektronik - tritt das oben diskutierte Problem in verschärfter Form auf. Bauelemente der Leistungselektronik führen über großflächige Kontakte nicht nur die thermische Verlustleistung ab, sondern parallel dazu große elektrische Leistungen den Bauelementen zu oder von den Bauelementen ab. Dies bedeutet, dass Lötverbindungen mit einem signifikanten Lunkeranteil die Funktion eines leistungselektronischen Bauelements gleichzeitig sowohl von der thermischen als auch von der elektrischen Seite her gefährden können. Die weitest gehende Vermeidung von Fehlstellen in Lötverbindungen in leistungselektronischen Bauelementen ist somit für deren Zuverlässigkeit von eminenter Wichtigkeit.

Die Problematik der Gaseinschlüsse in Lötstellen ist bereits seit längerem bekannt. Ferner ist aus grundlegenden physikalischen Gesetzen ebenfalls bereits seit langer Zeit bekannt, dass sich der Anteil von Gasblasen in Flüssigkeiten senken lässt, wenn die Flüssigkeiten einem Unterdruck ausgesetzt werden.

Die Patentschrift DE 199 11 887 C1 der Anmelderin beschreibt die Anwendung dieses Prinzips für eine Dampfphasen-Lötanlage, die mit gesättigtem Dampf arbeitet. Das Lötgut wird in dem heißen inerten Dampf der Dampfphasen-Lötanlage aufgeheizt und das Lötgut wird sodann bei geschmolzenem Lotmaterial aus der Dampfdecke befördert und mit Hilfe einer Vakuumhaube einem Unterdruck ausgesetzt.

Die DE 102 37 494 A1 offenbart ein Verfahren zum Löten in der Dampfphase, wobei in der Dampfphase nach dem Schmelzen des Lotes auf dem Lötgut um das Lötgut herum ein Unterdruck erzeugt wird.

Die Offenlegungsschrift DE 195 06 763 A1 betrifft ein Verfahren zum Löten bestückter Leiterplatten, bei dem die Leiterplatten oder sonstige Baugruppen in eine gegen die Umgebung gasdicht abgeschlossene Kammer eingebracht werden. In dieser Offenlegungsschrift wird vorgeschlagen, dem Prozeßgas vor der Plasmaanregung und/oder dem aus dem Prozeßgas erzeugten Plasma in einem Umfang von bis zu 10 Vol.-% säurenhafte Aktivatoren wie Ameisensäure oder Zitronensäure zuzumischen und mit dieser Mischung die Plasmaeinwirkung durchzuführen.

Die DE 198 23 527 A1 betrifft ein Verfahren zum Verbinden von elektronischen Bauelementen mit einem Substrat mittels Reflow-Löten, wobei das Aufheizen und Verlöten des bestückten Substrats bei einem Druck von weniger als 100 mbar erfolgt.

Die US 2005 / 0 563 324 A1 beschreibt ein Verfahren zum Herstellen eines Verbindungsaufbaus, der ein erstes und ein zweites Verbindungselement aufweist, die zwischen einer dazwischenliegenden Lotschicht gelötet werden. Das Verfahren weist die Schritte auf: Dekomprimieren der Lotschicht auf einen ersten Druck unter Beibehaltung einer ersten Temperatur, die geringer ist als die Liquidustemperatur des Lots; Erwärmen der Lotschicht auf eine zweite Temperatur, die größer als die Liquidustemperatur des Lots ist; Komprimieren der Lotschicht auf einen zweiten Druck unter Beibehaltung der zweiten Temperatur, wobei der zweite Druck größer als der erste Druck ist; und Verfestigen des Lots unter Beibehaltung des zweiten Drucks.

Die EP 1350 588 A2 bezieht sich auf ein Verfahren zum Herstellen eines Halbleiter-Geräts, das wenige Lunker in seinen Lötverbindungsschichten aufweist, durch Kontaktieren eines Laminats für eine kurze Zeitdauer unter Verwendung eines Lötprozesses.

Die WO 2007 / 088 695 A1 beschreibt eine Reflow-Kammer, deren Normaldruck auf einen Einstelldruck eingestellt wird, der höher als der Normaldruck ist, durch Einführen eines reduzierenden Gases in die Reflow-Kammer. In dem Zustand in dem die Reflow-Kammer mit einem Druck beaufschlagt ist, wird ein Objekt, das gelötet werden soll in der Reflow-Kammer erwärmt und dann gekühlt. Ein Halbleiterelement wird gelötet und Lunker werden dadurch unterdrückt.

Die EP 1968 108 A1 bezieht sich auf ein Lötverfahren. Ein zu lötendes Objekt wird in eine druckdichte Kammer eingebracht. Ein interner Druck der Kammer wird auf einen Normaldruck oder einen Überdruck durch Einbringen eines reduzierenden Gases in die Kammer erhöht. Ein Löten eines Halbleiterelements bezüglich einer Leiterplatte wird in dem Druckzustand ausgeführt.

Die US 2010 / 0 320 258 A1 beschreibt ein erstes Substrat, das erste Lötpunkte aufweist und ein zweites Substrat, das zweite Lötpunkte aufweist, die gestapelt sind, während die Lötpunkte temporär aneinander geheftet werden. Dann wird der Stapel in einem Ofen angeordnet. Das Gas wird aus dem Ofen abgesaugt, um einen Unterdruck zu erzeugen. Sodann wird ein Carbonsäure-haltiges Gas in den Ofen eingeführt. Während einer Temperaturerhöhung in dem Ofen wird das Gas auf einen Unterdruck abgesaugt bei einer Temperatur im Bereich einer Reduktionstemperatur einer Oxidschicht durch das Carbonsäure-haltige Gas, um die Schmelztemperatur der Lötpunkte zu verringern.

Die Patentschrift US 4 358 662 offenbart ein elektrisches Löteisen, das einen verlängerten Erwärmungszylinder aufweist, der sich von einem Griff z einer Lötspitze erstreckt, die aus dem Ende des Zylinders herausragt. Das Löteisen wird mit einer thermisch isolierten Rauchabzugsbefestigung bereitgestellt, die koaxial um den Zylinder positioniert ist und die Spitze umgibt zum Abziehen von störenden Qualmen, Gasen, Rauchen oder anderen Luft-gebundenen Schadstoffen von der Lötstellen.

Die Patentschrift US 5 185 509 beschreibt eine Roboter-kontrollierte Lötvorrichtung, die einen Vorsprung und einen komplementär geformten Sockel aufweist zum Definieren einer universellen Gelenks zum Bereitstellen einer pendelnden Bewegung, um eine unerwünschte Verschiebung der Roboter-Kontrolleinheit verhindern zu helfen.

Die Offenlegungsschrift DE 196 09 877 A1 schlägt eine Vorrichtung zum Wellenlöten von Werkstücken vor, bei der die letzte Lotwelle unter einem bestimmten Winkel entgegen der Transportvorrichtung der Werkstücke strömt. Durch die gewählte Wellengeometrie wird die Bildung von Lotbrücken und unerwünschten Lotanhäufungen auf den Werkstücke vermieden. Dadurch entfällt die Notwendigkeit der Einhaltung eines bestimmten Lötwinkels, so dass die Transportvorrichtung für die Werkstücke horizontal angeordnet werden kann.

Die DE 44 32 402 A1 bezieht sich auf eine Vorrichtung zum flussmittelfreien Löten von über die Lötwelle einer Schwalllötdüse geführten Leiterplatten, wobei die Lötmittel mittels mindestens einer Ultraschallelektrode (Sonotrode) in Schwingungen versetzt wird, die Oberfläche der Sonotrode unmittelbar von der Lötwelle umspült wird und die Leiterplatten dicht über die Oberfläche der Sonotrode geführt werden. Dabei ist vorgesehen, dass die Oberfläche der Sonotrode mindestens einen Teilbereich der Oberfläche des Wellenformers der Schwall-Lötdüse bildet.

Die Offenlegungsschrift DE 42 25 378 A1 betrifft ein Verfahren zum Verlöten, insbesondere auch flussmittelfreies Verlöten von mit Bauteilen bestückten Leiterplatten oder dergleichen, wobei der Lötvorgang und gegebenenfalls vorhandene vor-, zwischen- oder nachgeschaltete Schritte unter Niederdruck und unter der Plasmawirkung einer speziellen Prozessgas-Atmosphäre eingeführt werden.

Die DE 10 2006 027 027 A1 offenbart ein Lötververfahren zum lunkerfreien Reflow-Löten von Fügepartnern unter Vakuum in einem Rezipienten wie etwa elektrische Bauteile auf Leiterplatten, wobei bei Erreichen des erforderlichen Unterdrucks ein Plasma im Rezipienten gezündet wird.

Die DE 10 2007 005 345 A1 betrifft ein Verfahren zum Reflow-Löten von Baugruppen in einer abgeschotteten Kammer unter Beheizung der Kammer. Im ersten Schritt wird der Druck in der Kammer gegenüber dem atmosphärischen Druck verstärkt und die Temperatur in der Kammer durch Konvektionsheizung zum Schmelzen der Lötpaste erhöht und im zweiten Schritt wird der Druck, gesteuert auf atmosphärischen Druck, unter Aufrechterhaltung der Temperatur wieder abgesenkt.

Die DE 10 2009 028 865 offenbart eine Reflowlötanlage zum Durchlauflöten von Lötgut mit einer Vakuumzone, die sich an die Lötzone anschließt, wobei in der Vakuumzone das Lötgut für eine bestimmte Zeitspanne zumindest auf einer Temperatur gehalten wird, die der Schmelztemperatur entspricht oder darüber liegt, bevor das Lötgut an die Kühlzone übergeben wird.

Die WO 2207 / 088 695 A1 offenbart eine Reflow-Lötanlage mit einer Druckkammer mit deren Hilfe während des Lötprozesses sowohl ein Unterdruck als auch ein Überdruck durch Einlassen eines reduzierenden Gases an das Lötgut angelegt werden kann. Zur Unterdrückung von Lunkern wird während des Lötvorgangs ein Überdruck angelegt.

Die PCT Anmeldung WO 2005/087422 A1 offenbart eine Dampfphasen-Lötanlage, bei der eine Vakuumkammer in der Dampfdecke der Prozesskammer angeordnet ist, die über das Lötgut geschoben werden kann. Bei geschlossener Vakuumkammer wird der zum Aufheizen des Lötguts verwendete Dampf abgesaugt und dadurch das Lötgut einem Unterdruck ausgesetzt. Zum Entfernen von Flussmittelresten kann das Lötgut bereits vor dem Schmelzen der Lotpaste einem Unterdruck ausgesetzt werden.

Die Broschüre "CondensoX, Reflow Condensation Soldering System" (www.rehm-group.com) offenbart eine Dampfphasen-Lötanlage, die mit ungesättigtem Dampf arbeitet. In der Phase, in der das Lotmaterial eine Temperatur oberhalb der Liquidustemperatur aufweist, kann ein Unterdruck in der hermetisch dichten Prozesskammer hergestellt werden.

Die oben zitierten Verfahren und Vorrichtungen sind in der Lage, die Problematik der Lunkerbildung, insbesondere bei großflächigen Lötverbindungen zu entschärfen, in dem sie einen Teil des Volumens der Gaseinschlüsse beseitigen und die Größe des Volumens der verbleibenden Gaseinschlüsse einer Lötverbindung verkleinern. Die zitierten Dokumente weisen jedoch gemeinsam die Problematik auf, dass noch immer ein signifikanter Anteil an Lunkern in Lötverbindungen verbleiben kann, der bei kritischen Anwendungen nicht toleriert werden kann, da dadurch die Funktionsfähigkeit und/oder die Zuverlässigkeit der gelöteten Bauelemente beeinträchtigt wird. Vor diesem Hintergrund hat die Anmelderin nochmals umfassend die Problematik der Bildung von Lunkern in Lötstellen untersucht.

Der vorliegenden Erfindung liegt daher das Problem zu Grunde, Vorrichtungen anzugeben, mit deren Hilfe der Einfluss von Fehlstellen (Lunker) auf Lötverbindungen verringert werden kann.

### 3. Zusammenfassung der Erfindung

Gemäß einem ersten Ausführungsbeispiel der vorliegenden Erfindung wird dieses Problem durch eine Vorrichtung nach Anspruch 1 gelöst. In einer Ausführungsform weist eine Vorrichtung zum Reflow-Löten (a) zumindest eine Wärmequelle auf, die ausgebildet ist, um ein Lotmaterial zumindest bis auf eine Liquidustemperatur zu erwärmen, und (b) zumindest eine Unterdrucksteuerungsvorrichtung, die ausgebildet ist, um zumindest zweimal einen Unterdruck um das Lotmaterial während eines Zeitintervalls zu erzeugen, in der das Lotmaterial eine Temperatur aufweist, die größer oder gleich der Liquidustemperatur ist.

Durch das Anlegen eines Unterdrucks an das Lotmaterial während eines Zeitintervalls, in der sich dieses in flüssigem Zustand befindet, kann ein Teil der in dem flüssigen Lotmaterial vorhandenen Gaseinschlüsse aus dem Lötmaterial entfernt werden. Die Anmelderin hat nun erkannt, dass durch ein Entfernen des Unterdrucks und durch ein erneutes Anlegen des Unterdrucks an das noch flüssige Lotmaterial das Volumen der Gaseinschlüsse in den erzeugten Lötverbindungen nochmals deutlich reduziert werden kann.

Nicht der Betrag des Unterdruck selber, sondern die Differenz zwischen dem außen an dem Lötmaterial anliegenden Druck und dem in den Gaseinschlüssen herrschendem Druck ist die Ursache für das Reduzieren des Volumens von in dem flüssigen Lotmaterial eingeschlossen Gasblasen. Bis zum Anlegen eines bestimmten Unterdrucks, der mit einem entsprechenden Druckgradienten korreliert, verringert sich das Volumen, der in einem Lotmaterial vorhandenen Gaseinschlüsse. Ist ein bestimmter Unterdruck erreicht, kommt die Gaseinschluss reduzierende Wirkung des Unterdrucks jedoch zum Erliegen. Der Druckgradient zwischen dem Umgebungsdruck und dem in den Gaseinschlüssen herrschenden Druck reicht nicht mehr aus, das Volumen der in dem flüssigen Lotmaterial enthaltenden Gasblasen zu verringern. Eine weitere Verringerung des Unterdrucks und/oder ein längeres Aufrechterhalten eines bestimmten Unterdrucks verringern das zu diesem Zeitpunkt noch verbliebene Volumen der Gaseinschlüsse in dem flüssigen Lotmaterial nicht weiter.

Neben den oben diskutierten Ursachen für das Entstehen von Lunkern in Lötverbindungen bilden Ausgasungen von Leiterplatten, Bauelementgehäusen und/oder von Vergussmassen weitere Quellen für das Entstehen von Gaseinschlüssen in gelöteten Verbindungen. Leiterplatten bestehen ebenso wie die Gehäuse von Bauelementen häufig zu erheblichen Anteilen aus Kunststoffen, die nach ihrer Herstellung über längere Zeiträume gasförmige Bestandteile abgeben, bevor sie ihre endgültige Zusammensetzung erreichen. Das Gleiche gilt für die kunststoffhaltigen Vergussmassen innerhalb der Bauelementgehäuse mit denen empfindliche Bauteile vor den aggressiven Bestandteilen der Luft geschützt werden sollen und/oder ein Spannungsüberschlag verhindert werden soll. Aufgrund des wirtschaftlichen Drucks wird der Lagerungsprozess der kunststoffhaltigen Komponenten zunehmend verkürzt und/oder abgebrochen bevor die Kunststoffe ihre endgültige Zusammensetzung erreicht haben. Darüber hinaus sind Kunststoffe häufig hygroskopisch und speichern erhebliche Mengen von Feuchtigkeit.

Die hohen für einen Lötprozess notwendigen Temperaturen setzen einen beschleunigten Ausgasungsprozess aus den Leiterplatten, den Gehäuseteilen und/oder den Vergussmassen in Gang. Zusätzlich wird bei den erhöhten Temperaturen während eines Lötprozesses ein Teil der in den Kunststoffen gespeicherten Feuchtigkeit freigesetzt. Ein Teil der Ausgasungen und der Feuchtigkeitsbestandteile kann als gasförmige Einschlüsse oder Lunker in Lötverbindungen eingeschlossen werden. Anders als das Lotmaterial entfalten diese Prozesse ihre gasliefernde Wirkung verstärkt bei den hohen Temperaturen bei denen das Lotmaterial bereits geschmolzen ist. Ein erster Vakuumschritt oder Unterdruckzyklus kann deshalb nur einen Teil des durch diese Mechanismen in das flüssige Lotmaterial eingebrachten Gasvolumens beseitigen.

Durch das Anlegen eines zweiten Unterdrucks an das noch flüssige Lotmaterial entfernt die Wirkung des damit einhergehenden zweiten Druckgradienten einen weiteren Teil des noch vorhandenen und/oder des bei den hohen Temperaturen im Bereich der Liquidustemperatur neu gebildeten Gasvolumens aus dem Lotmaterial.

In einem weiteren Aspekt ist die Unterdrucksteuerungsvorrichtung ferner ausgebildet, den Unterdruck zumindest zweimal im Wesentlichen ohne zeitlichen Abstand zu erzeugen.

Damit wird es möglich, das Zeitintervall, in dem das Lotmaterial flüssig gehalten werden muss, kurz zu halten und gleichzeitig den Anteil der Gaseinschlüsse in dem erstarrten Lotmaterial auf ein Minimum zu verkleinern.

Der Ausdruck "Unterdruck" bedeutet hier wie an anderen Stellen dieser Beschreibung, dass von einem Umgebungsdruck (1013,25 mbar bei Normalbedingungen) ausgehend, der Betrag des Drucks um das Lotmaterial auf einen vorbestimmten Wert unterhalb des Umgebungsdrucks abgesenkt wird, der Zahlenwert des erzeugten Drucks gegebenenfalls für eine bestimmte Zeitdauer aufrechterhalten wird und dann in kontrollierter Weise wieder der Umgebungsdruck um das Lotmaterial hergestellt wird. Sämtlich in dieser Beschreibung angegeben Zahlenwerte von Druckangaben sind absolute Druckwerte.

Bei einem zweimaligen Erzeugen eines Unterdrucks kann am Ende des ersten Unterdruckzyklus der Unterdruck auf den Umgebungsdruck angehoben werden, so dass der anschließende zweite Unterdruckzyklus ebenfalls vom Umgebungsdruck ausgehend beginnt. Es ist jedoch nicht notwendig, dass das Druckmaximum zwischen dem ersten und dem zweiten Druckzyklus den Umgebungsdruck erreicht. Vielmehr kann der zweite Druckzyklus oder weitere Druckzyklen auch beginnend von einem Wert zwischen dem Umgebungsdruck und dem Druck im Druckminimum des ersten Druckzyklus ausgeführt werden. Insbesondere ist es günstig, wenn das Druckmaximum zwischen dem ersten und dem zweiten Druckzyklus zumindest den Umgebungsdruck minus 50 % der Druckdifferenz zwischen dem Umgebungsdruck und dem Druck im Druckminimum des Unterdrucks des ersten Druckzyklus erreicht.

In einem vorteilhaften Aspekt ist die Unterdrucksteuerungsvorrichtung ferner ausgebildet zumindest einen weiteren Unterdruck vor Erreichen der Liquidustemperatur zu erzeugen.

Indem eine zu lötende Baugruppe vor Beginn des Lötprozesses einem Unterdruckzyklus unterworfen wird, kann bereits im Vorfeld ein Teil der Lösemittel und/oder des Flussmittels des Lotmaterials abgesaugt werden. Dieser Teil steht für die Bildung von Fehlstellen oder Lunkern in dem nachfolgenden Lötprozess nicht mehr zur Verfügung.

Wie bereits oben erwähnt, können durch das Anlegen eines Unterdrucks vor dem Lötprozess Lufteinschlüsse zwischen einem Bauelement und dem Lotmaterial, das beispielsweise in Form von Lotpaste vorliegt, die beim Aufsetzen eines Bauelements auf das bzw. die Lötpads erzeugt wurden, vor dem eigentlichen Lötprozess zumindest zum Teil entfernt werden. Schließlich beschleunigt ein Unterdruck ähnlich wie eine erhöhte Temperatur die Ausgasungen der Leiterplatte, der kunststoffhaltigen Gehäuseteile und/oder der Vergussmassen. Durch das Absaugen zumindest eines Teils dieser Gasfreisetzungen wird das potentiell für die Lunkerbildung im nachfolgenden Lötprozess vorhandene Gasvolumen reduziert und damit der Lunkeranteil der erzeugten Lötverbindungen verkleinert.

In einem anderen Aspekt ist die Unterdrucksteuerungsvorrichtung ausgebildet, einen Druck im Bereich von 0,1 mbar bis 500 mbar, bevorzugt von 1 mbar bis 100 mbar und am meisten bevorzugt von 2 mbar bis 50 mbar zu erzeugen. Gemäß einem weiteren Aspekt ist die Unterdrucksteuerungsvorrichtung ausgebildet, den erzeugten Druck über einen Zeitraum von 1 ms bis 50 s, bevorzugt von 10 ms bis 10 s und am meisten bevorzugt von 100 ms bis 5 s zu halten. Nach noch einem anderen Aspekt ist die Unterdrucksteuerungsvorrichtung ferner ausgebildet, eine Druckabnahme im Bereich von 10 mbar/s bis 1000 mbar/s, bevorzugt von 20 mbar/s bis 500 mbar/s und am meisten bevorzugt von 50 mbar/s bis 200 mbar/s zu erzeugen.

Es ist vorteilhaft, die Schwelle, bis zu der ein Unterdruck das in dem Lotmaterial eingeschlossene Volumen reduziert, möglichst zügig zu erreichen, diesen Zustand nur für eine kurze Zeitspanne aufrechtzuerhalten, schnell in den Ausgangszustand zurückzukehren und den Unterdruckprozess umgehend ein zweites Mal zu durchlaufen. Damit kann einerseits der Fehlstellenanteil der gebildeten Lötstellen und andererseits die thermische Belastung der Bauelemente einer zu lötenden Baugruppe minimiert werden.

In einem anderen Aspekt weist die Unterdrucksteuerungsvorrichtung eine Heizeinrichtung auf, die ausgebildet ist, die Temperatur des Lotmaterials über der Liquidustemperatur zu halten.

Damit kann sichergestellt werden, dass das flüssige Lotmaterial zwei Unterdruckzyklen durchlaufen kann, bevor das Lotmaterial zu erstarren beginnt, auch wenn die Temperatur des Lotmaterials zu Beginn der Unterdruckzyklen nur wenige Grad Celsius über dessen Liquidustemperatur lag. Dadurch wird es möglich, die thermische Belastung der Bauelemente und der Leiterplatte der zu lötenden Baugruppe zu begrenzen.

Gemäß nach noch einem anderen Aspekt weist die Unterdrucksteuerungsvorrichtung einen Temperatursensor auf, der ausgebildet ist, die Temperatur des Lotmaterials zu bestimmen.

Nach noch einem weiteren Aspekt weist die Vorrichtung zum Reflow-Löten ferner zumindest eine Überdrucksteuerungsvorrichtung auf, die ausgebildet ist, um zumindest einen Überdruck um das Lotmaterial während eines Zeitintervalls zu erzeugen, in dem eine Temperatur des Lotmaterials von einer ersten Temperatur, die größer oder gleich der Liquidustemperatur ist, auf eine zweite Temperatur unterhalb der Liquidustemperatur absinkt.

Durch das Anlegen eines Überdrucks an das flüssige Lotmaterial können die nach dem zweiten Überdruckzyklus noch vorhandenen Gaseinschlüsse komprimiert werden. Indem das Lotmaterial erstarrt während der Überdruck um das Lotmaterial anliegt, kann der Zustand der komprimierten Fehlstellen eingefroren oder konserviert werden. Damit kann der Lunkeranteil der erzeugten Lötverbindungen nochmals verringert werden.

Der Ausdruck "Überdruck" bedeutet hier wie an anderen Stellen dieser Beschreibung, dass von einem Umgebungsdruck ausgehend, der Betrag des Drucks um das Lotmaterial auf einen vorbestimmten Wert oberhalb des Umgebungsdrucks angehoben wird, der Zahlenwert des erzeugten Drucks für eine bestimmte Zeitdauer aufrechterhalten wird und dann in kontrollierter Weise wieder der Umgebungsdruck um das Lotmaterial hergestellt wird.

Nach noch einem anderen Aspekt ist die Überdrucksteuerungsvorrichtung ausgebildet, einen Druck im Bereich von 1,1 bar bis 50 bar, bevorzugt von 1,5 bar bis 10 bar und am meisten bevorzugt von 2 bar bis 5 bar zu erzeugen. Gemäß einem weiteren Aspekt ist die Überdrucksteuerungsvorrichtung ausgebildet, den erzeugten Druck über einen Zeitraum von 1 s bis 1000 s, bevorzugt von 5 s bis 200 s und am meisten bevorzugt von 10 s bis 100 s zu halten. In noch einem weiteren Aspekt ist die Überdrucksteuerungsvorrichtung ferner ausgebildet, einen Druckanstieg im Bereich von 10 mbar/s bis 1000 mbar/s, bevorzugt von 20 mbar/s bis 500 mbar/s und am meisten bevorzugt von 50 mbar/s bis 200 mbar/s zu erzeugen.

In einem bevorzugten Aspekt weist die Vorrichtung zum Reflow-Löten ferner zumindest eine Kühlvorrichtung auf, wobei die Kühlvorrichtung ausgebildet ist, die Temperatur des Lotmaterials von der ersten Temperatur auf die zweite Temperatur abzusenken, während die Überdrucksteuerungsvorrichtung den Überdruck um das Lotmaterial erzeugt.

Durch ein kontrolliertes aktives Kühlen der erwärmten Baugruppe und damit des Lotmaterials kann die thermische Belastung der zu lötenden Bauelemente und der sie tragenden Leiterplatte begrenzt werden. Darüber hinaus kann damit die Taktzeit eines Lötprozesses verkürzt und damit der Durchsatz der Lötanlage vergrößert werden.

In einem bevorzugten Aspekt ist die Unterdrucksteuerungsvorrichtung ferner ausgebildet zumindest ein vorgegebenes Unterdruckprofil zu erzeugen. Gemäß einem weiteren günstigen Aspekt ist die Überdrucksteuerungsvorrichtung ausgebildet zumindest ein vorgegebenes Überdruckprofil zu erzeugen.

Durch Anpassen des bzw. der Druckprofile an die zu lötende Baugruppe kann der Lötprozess hinsichtlich der thermischen und der Druckanforderungen an die zu lötenden Bauelemente optimiert werden.

Gemäß einem günstigen Aspekt sind die Unterdrucksteuerungsvorrichtung und die Überdrucksteuerungsvorrichtung als eine gemeinsame Drucksteuerungsvorrichtung ausgebildet.

Dieses Merkmal ermöglicht die Konstruktion einer kompakten Reflow-Lötanlage. Gleichzeitig wird die Komplexität des Transportsystems für das Lötgut in der Reflow-Lötanlage beschränkt. Insgesamt optimiert somit diese Ausführungsform das Zeitintervall in dem das Lotmaterial für die Unterdruckzyklen und ggf. für den Überdruckzyklus in flüssigem Zustand gehalten werden muss.

Nach einem anderen Aspekt ist die Unterdrucksteuerungsvorrichtung ausgebildet, einen ersten Unterdruck um das Lotmaterial vor Erreichen der Liquidustemperatur zu erzeugen, einen zweiten und einen dritten Unterdruck um das Lotmaterial während des Zeitintervalls zu erzeugen, in dem das Lotmaterial eine Temperatur aufweist, die größer oder gleich der Liquidustemperatur ist und die Überdrucksteuerungsvorrichtung ist ausgebildet, den Überdruck um das Lotmaterial während des Zeitintervalls zu erzeugen, in dem die Temperatur des Lotmaterials von der ersten auf die zweite Temperatur absinkt.

Nach einem weiteren Aspekt ist die Vorrichtung zum Reflow-Löten als eine Dampfphasen-Lötanlage ausgebildet.

Das erfindungsgemäße Prinzip des zweimaligen Anlegens eines Unterdrucks an das flüssige Lotmaterial kann besonders einfach in einer Dampfphasen-Lötanlage realisiert werden. Darüber hinaus sind Dampfphasen-Lötanlagen besonders geeignet zum Löten von großflächigen und versteckt liegenden oder schwer zugänglichen Lötstellen, da insbesondere Lötanlagen, die mit gesättigtem Dampf arbeiten, konzeptionsbedingt eine Überhitzung von Teilen der zu lötenden Baugruppe verhindern.

Gemäß einem anderen Aspekt ist die Vorrichtung zum Reflow-Löten als Konvektions-Reflow-Lötanlage ausgebildet.

Konvektions-Reflow-Lötanlagen sind eine Ausprägungsform von Reflow-Lötanlagen. Damit gelten für diese Lötanlagen die oben gemachten Ausführungen entsprechend.

In einem weiteren Aspekt weist die Vorrichtung zum Reflow-Löten eine Transportvorrichtung für das Lotmaterial auf, das dieses in die Unterdrucksteuerungsvorrichtung bzw. die Überdrucksteuerungsvorrichtung befördert.

Eine solche Ausführungsform kann für Konvektions-Reflow-Lötanlagen günstig sein.

Nach einem anderen Aspekt ist die Unterdrucksteuerungsvorrichtung bzw. die Überdrucksteuerungsvorrichtung ferner ausgebildet, um zum Lotmaterial bewegt zu werden. Gemäß einem weiteren günstigen Aspekt befördert die Transportvorrichtung das Lotmaterial einen ersten Teil eines Abstandes zwischen der Wärmequelle und der Unterdrucksteuerungsvorrichtung bzw. der Überdrucksteuerungsvorrichtung und die Unterdrucksteuerungsvorrichtung bzw. die Überdrucksteuerungsvorrichtung ist bewegbar ausgebildet, um einen zweiten Teil des Abstandes zwischen der Wärmequelle der Unterdrucksteuerungsvorrichtung bzw. der Überdrucksteuerungsvorrichtung zu überbrücken.

Diese Ausführungsbeispiele können für Dampfphasen-Lötanlagen vorteilhaft sein.

Gemäß einem zweiten Ausführungsbeispiel wird das Problem der vorliegenden Erfindung durch eine Vorrichtung nach Anspruch 10 gelöst. In einer Ausführungsform weist eine Vorrichtung zum Bügellöten (a) zumindest eine Wärmequelle auf, die in mechanischem Kontakt mit einer zu lötenden Baugruppe kommt und die ausgebildet ist, um ein Lotmaterial zumindest bis auf eine Liquidustemperatur zu erwärmen; und (b) zumindest eine Unterdrucksteuerungsvorrichtung, die ausgebildet ist, um zumindest einen Unterdruck während eines Zeitintervalls zu erzeugen, in dem die Wärmequelle das Lotmaterial noch nicht bis zumindest auf die Liquidustemperatur erwärmt hat.

Eine Bügel-Lötanlage ist eine Ausprägungsform einer Reflow-Lötanlage. Die Anmelderin hat erkannt, dass sich die oben erläuterten Vorteile des Anlegens eines Unterdrucks an eine zu lötende Baugruppe vor Beginn eines Reflow-Lötprozesses auch für Bügel-Lötanlagen realisieren lassen.

In einem weiteren Aspekt ist die zumindest eine Wärmequelle in Form eines Bügels oder eines Stempels ausgebildet, um zumindest zwei oder alle Lötanschlüsse zumindest eines Bauelements gleichzeitig zu erwärmen und damit zu verlöten.

In einem anderen Aspekt ist die Unterdrucksteuerungsvorrichtung ausgebildet, einen Druck im Bereich von 0,1 mbar bis 500 mbar, bevorzugt von 1 mbar bis 100 mbar und am meisten bevorzugt von 2 mbar bis 50 mbar zu erzeugen. Gemäß einem weiteren Aspekt ist die Unterdrucksteuerungsvorrichtung ausgebildet, den erzeugten Druck über einen Zeitraum von 1 ms bis 50 s, bevorzugt von 10 ms bis 10 s und am meisten bevorzugt von 100 ms bis 5 s zu halten. Nach noch einem anderen Aspekt ist die Unterdrucksteuerungsvorrichtung ferner ausgebildet, eine Druckabnahme im Bereich von 10 mbar/s bis 1000 mbar/s, bevorzugt von 20 mbar/s bis 500 mbar/s und am meisten bevorzugt von 50 mbar/s bis 200 mbar/s zu erzeugen.

Gemäß einem dritten Ausführungsbeispiel wird das Problem der vorliegenden Erfindung durch eine Vorrichtung nach Anspruch 12 gelöst. In einer Ausführungsform weist eine Vorrichtung zum Wellenlöten oder zum Selektivlöten (a) zumindest eine Vorrichtung auf, die ausgebildet ist, um zumindest eine Welle flüssigen Lotmaterials zu erzeugen, die mit zumindest einer zu lötenden Baugruppe in Kontakt kommt, und (b) zumindest eine Unterdrucksteuerungsvorrichtung, die ausgebildet ist, um zumindest einen Unterdruck um die zumindest eine zu lötende Baugruppe während einer Zeit zu erzeugen in der die Welle flüssigen Lotmaterials mit der zumindest einen zu lötenden Baugruppe in Kontakt kommt.

Eine Selektiv-Lötanlage stellt eine Variante einer Wellen-Lötanlage dar, wobei nicht die ganze zu lötende Baugruppe sondern nur ein kleiner Teil und/oder nur ein einzelnes Bauelement mit einer kleinen oder Miniaturwelle gelötet werden.

Wellen-Lötanlagen oder Selektiv-Lötanlagen zählen nicht zu den Reflow-Lötanlagen.

In einem anderen Aspekt ist die Unterdrucksteuerungsvorrichtung ausgebildet, einen Druck im Bereich von 0,1 mbar bis 500 mbar, bevorzugt von 1 mbar bis 100 mbar und am meisten bevorzugt von 2 mbar bis 50 mbar zu erzeugen.

Schließlich ist nach einem weiteren Aspekt die die Unterdrucksteuerungsvorrichtung ferner ausgebildet, zumindest einen weiteren Unterdruck vor Erreichen der Liquidustemperatur zu erzeugen.

### 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei
- Fig. 1: eine schematische Darstellung eines Lotpastenauftrags eines großflächigen Lötanschlusses mit aufgesetztem Bauelement darstellt;
- Fig. 2: einen schematischen Schnitt durch eine Dampfphasen-Lötanlage mit einer Unterdrucksteuerungsvorrichtung und einer zu lötenden Baugruppe zeigt;
- Fig. 3: die Fig. 2 wiedergibt, wobei die zu lötende Baugruppe in der Unterdrucksteuerungsvorrichtung angeordnet ist;
- Fig. 4: einen Temperaturverlauf eines Lötprozesses in einer Dampfphasen-Lötanlage und den Druckverlauf eines Unterdruckzyklus gemäß dem Stand der Technik veranschaulicht;
- Fig. 5: schematisch verschiedene Gaseinschlüsse in flüssigem Lotmaterial illustriert;
- Fig. 6: schematisch den Verlauf des Volumens eines Gaseinschlusses der Fig. 5 während des in der Fig. 4 dargestellten Unterdruckverlaufs wiedergibt;
- Fig. 7: schematisch den Lunkeranteil der in der Fig. 5 dargestellten Lötstelle kurz nach dem Unterschreiten der Liquidustemperatur zeigt;
- Fig. 8: den Temperaturverlauf eines Lötprozesses in einer Dampfphasen-Lötanlage und den Druckverlauf zweier Unterdruckzyklen darstellt;
- Fig. 9: den Lunkeranteil der in den Figuren 5 und 7 gezeigten Lötverbiindung am Ende des zweiten Unterdruckzyklus veranschaulicht;
- Fig. 10: eine Lötverbindung zwischen einer flexiblen Leiterplatte und einem Bauelement darstellt, wobei der Lötprozess ohne einen Vakuumschritt ausgeführt wurde;
- Fig. 11: die Lötverbindung der Fig. 10 angibt, wobei der Lötprozess einen Unterdruckzyklus aufwies;
- Fig. 12: die Lötverbindung der Fig. 12 darstellt, wobei der Lötprozess mit zwei Unterdruckzyklen ausgeführt wurde;
- Fig. 13: eine Lötverbindung zwischen der Metallisierung einer Keramik und einem Bauelement wiedergibt, wobei der Lötprozess einen Vakuumschritt aufwies;
- Fig. 14: den Temperaturverlauf eines Lötprozesses in einer Dampfphasen-Lötanlage und den Druckverlauf mit einem Unterdruckzyklus vor dem Lötprozess und zwei Unterdruckzyklen in dem Zeitintervall darstellt, in dem das Lotmaterials flüssig ist;
- Fig. 15: eine schematische Darstellung des Lotpastenauftrags der Fig. 1 nach dem Durchlaufen eines Unterdruckzyklus vor dem Lötprozess veranschaulicht;
- Fig. 16: schematisch den Temperaturverlauf eines Lötprozesses in einer Dampfphasen-Lötanlage und den Druckverlauf eines Über-druckprozesses gemäß dem Stand der Technik illustriert;
- Fig. 17: schematisch das Volumen eines ausgewählten Lunkers der Fig. 5 (a) vor Beginn der Überdruckprozesse (b) am Unterschreiten der Liquidustemperatur und (c) am Ende des Überdruckzyklus illustriert;
- Fig. 18: schematisch den Temperaturverlauf eines Lötprozesses in einer Dampfphasen-Lötanlage und den Druckverlauf mit zwei Unterdruckzyklen und einem anschließenden Überdruckzyklus zeigt; und
- Fig. 19: den Lunkeranteil der Fig. 9 nach Abschluss des Überdruckprozesses der Fig. 18 angibt.

### 5. Detaillierte Beschreibung bevorzugter Ausführungsbeispiele

Im Folgenden werden bevorzugte Ausführungsformen einer erfindungsgemäßen Vorrichtung genauer erläutert.

Die Fig. 1 zeigt schematisch ein leistungselektronisches Bauelement 100, das ganzflächig auf eine Metallisierung 120 einer Keramik 110 aufgelötet werden soll. Die Keramik 110 kann beispielsweise Aluminiumoxid (Al₂O₃) oder Aluminiumnitrid (AlN) umfassen. Das Bauelement 100 umfasst ein strukturiertes Substrat 140, an dessen Oberseite die elektrischen Lastanschlüsse 170 sowie der Steueranschluss 175 angebracht sind. Der Halbleiterchip 140 wird in dem in der Fig. 1 dargestellten Beispiel, durch die Vergussmasse 150 und das darüber angeordnet Gehäuse 160 vor Umgebungseinflüssen geschützt. Das in der Fig. 1 dargestellte leistungselektronische Bauelement 100 könnte beispielsweise ein Leistungs-MOSFET (metal oxide semiconductor field effect transistor) oder ein IGBT (insulated gate bipolar transistor) sein.

Auf die Metallisierung 120 wird zum Beispiel mit Hilfe einer Schablone Lotmaterial in Form von Lotpaste 130 mit einer durch die Schablonenstärke vorgegebenen Dicke aufgetragen. Übliche Werte eines Pastenauftrags liegen im Bereich von ungefähr 100 zum bis etwa 200 µm. Aufgrund der großen Fläche des Lotanschlusses erfolgt der Auftrag der Lotpaste 130 beim Schablonendruck nicht vollständig plan, vielmehr weisen die randnahen Bereiche der Lotpaste 130 eine geringfügig größere Höhe auf als die zentrumsnahen Bereiche. Somit wird bereits beim Aufsetzen des Bauelements 100 ein Luftvolumen 180 zwischen der Lotpaste 130 und dem Substrat 140 des Bauelements 100 eingeschlossen.

Lotpasten enthalten neben anderen Komponenten hauptsächlich Lötmetallpulver, Flussmittel und Lösemittel. Die flüchtigen Stoffe der Lotpaste 130 wie etwa das bzw. die Lösemittel und/oder die Flussmittelbestandteile gasen bereits vor dem Lötvorgang teilweise aus und vergrößern dadurch das zwischen dem Bauelement 100 und der Lotpaste 130 eingeschlossene Gasvolumen 180.

Für die großflächige Lötverbindung des Bauelements 100 der Fig. 1 ist eine Dampfphasen-Lötanlage, die mit gesättigtem Dampf als Wärmeübertragungsmedium arbeitet, besonders gut geeignet, da dieser Reflow-Lötanlagentyp konzeptbedingt eine Überhitzung von Teilen des Bauelements 100, der Lotpaste 130 und/oder der Leiterplatte 110 verhindert. Deshalb werden im Folgenden verschiedene Ausführungsbeispiele des erfindungsgemäßen Konzepts beispielhaft anhand dieses Lötanlagentyps erläutert. Es wird jedoch anerkannt, dass die nachfolgenden Ausführungen auch auf andere Reflow-Lötanlagen, wie etwa Konvektions-Reflow-Lötanlagen oder Bügel-Lötanlagen übertragen werden können. Darüber hinaus können zumindest Teilaspekte des dargelegten Konzepts auch vorteilhaft in anderen Lötanlagentypen wie etwa Wellen-Lötanlagen eingesetzt werden.

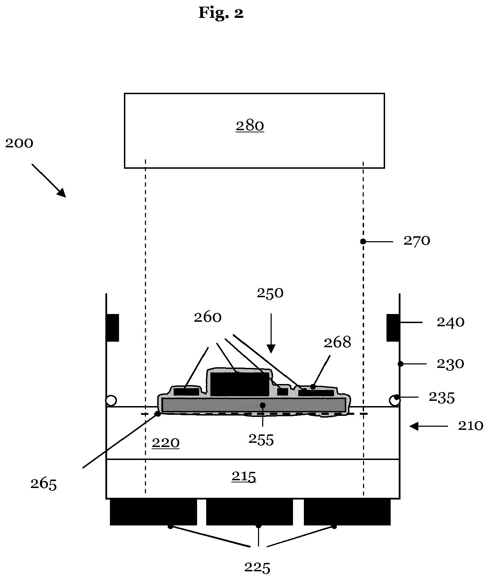

Die Fig. 2 zeigt schematisch einen Schnitt durch eine Prozesskammer 210 einer Dampfphasen-Lötanlage 200 mit einer Unterdrucksteuerungsvorrichtung 280. Eine Prozessflüssigkeit 215 füllt die Prozesskammer 210 bis zu einer bestimmten Höhe. In einer häufig gewählten Ausführungsform weist die Prozessflüssigkeit 215 eine Höhe von etwa einem Zentimeter auf. Die Prozessflüssigkeit 215 ist vorzugsweise chemisch inert und elektrisch nicht leitend. Als Prozessflüssigkeit 215 kann beispielsweise Perfluorpolyether oder eine Flüssigkeit eingesetzt werden, die bei einer vorgegebenen Temperatur siedet. Die Prozessflüssigkeit 215 wird so gewählt, dass ihr Siedepunkt der Löttemperatur der Bauelemente 260 der zu lötenden Baugruppe 250 entspricht.

Mit einer Heizvorrichtung 225, die sich in dem in der Fig. 2 dargestellten Beispiel aus drei Elementen zusammensetzt und unterhalb der Prozesskammer 210 angeordnet ist, wird die Prozessflüssigkeit 215 zunächst bis zu ihrem Siedepunkt erwärmt. Bei weiterer Energiezufuhr in die siedende Prozessflüssigkeit 215 steigt deren Temperatur nicht weiter an, sondern die Prozessflüssigkeit 215 verdampft. Der entstehende Dampf bildet eine Dampfdecke 220 über der Prozessflüssigkeit 215. Ein Teil des Dampfes kondensiert an den kalten Seitenwänden 230 der Prozesskammer 210 und erwärmt diese. Bei genügender Energiezufuhr durch die Heizvorrichtung 225 steigt die Dampfdecke 220 in der Prozesskammer 210 nach oben und erreicht schließlich die Oberkante der Prozesskammer 210. Bei einem weiteren Anstieg der Dampfdecke 220 über die Oberkante der Prozesskammer 210 hinaus würde es zu einem Verlust der teuren Prozessflüssigkeit 215 aus der Prozesskammer 210 kommen. Um dies zu verhindern, ist an der Oberkante der Prozesskammer 210 vorzugsweise eine zweite Kühleinrichtung 240 angebracht, an der der Dampf 220 kondensiert, der das obere Ende der Prozesskammer 210 erreicht.

In der Höhe, in der die zu lötende Baugruppe 250 in der Prozesskammer 210 erwärmt wird, ist in der beispielhaften Ausführungsform der Fig. 2 eine erste Kühlvorrichtung 235 in der Prozesskammer 210 angebracht. Die Kühleinrichtung 235 umfasst in der einfachsten Ausführung ein Rohr, das entlang einer oder mehrerer Seitenwände 230 an der Prozesskammer 210 angebracht ist. Durch kontrolliertes Durchführen eines Kühlmittels durch die Kühleinrichtung 235 wird diese unterhalb die Siedetemperatur der Prozessflüssigkeit 215 abgekühlt und somit die Höhe der Dampfdecke 220 eingestellt.

Die zu lötende Baugruppe 250 umfasst eine Leiterplatte 255 mit Lötpads auf die, wie in der Fig. 1 schematisch dargestellt, Lotpaste 130 mit einer vorgegebenen Dicke aufgetragen wird. Die Bauelemente 260 werden dann auf die Lotpaste tragenden Lötpads der Leiterplatte 255 aufgesetzt. Weder an die Leiterplatte 255 noch an die zu lötenden Bauelemente 260 werden besondere Anforderungen gestellt. Das in der Fig. 2 dargestellte Beispiel zeigt eine einseitig bestückte Baugruppe 250. Es wird jedoch anerkannt, dass eine Dampfphasen-Lötanlage 200 ebenfalls zweiseitig bestückte Leiterplatten 255 verarbeiten kann. Darüber hinaus kann das erfindungsgemäße Konzept selbstredend auch zum Reflow-Löten für zweiseitig bestückte Leiterplatten 255 angewendet werden. Schließlich kann das definierte Konzept ferner zum Reflow-Löten komplexer dreidimensionaler Strukturen eingesetzt werden.

In dem in der Fig. 2 beschriebenen Beispiel ist die zu lötende Baugruppe 250 auf einer Aufnahme 265 einer Transportvorrichtung 270 angeordnet. Die Transportvorrichtung 270 kann die Baugruppe 250 in die Prozesskammer 210 absenken und wieder aus ihr herausheben. Die Baugruppe 250 wird mit Hilfe einer zweiten Transportvorrichtung in die Prozesskammer 210 hinein und aus dieser heraus befördert (in der Fig. 2 nicht dargestellt). Das Steuerungs- bzw. Regelungssystem der Anlage 200 ist in der Fig. 2 aus Einfachheitsgründen ebenfalls nicht gezeigt.

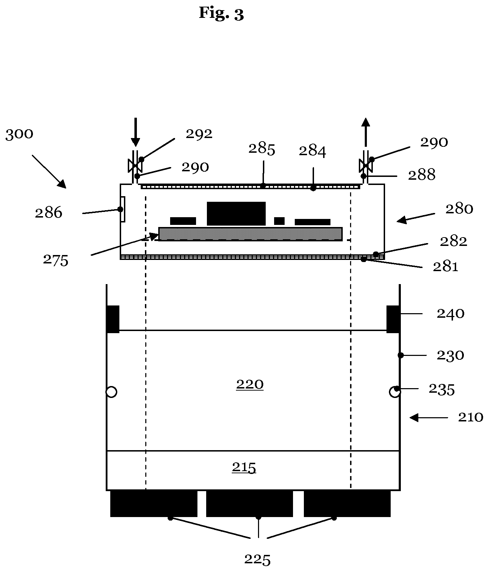

Die Dampfphasen-Lötanlage 200 umfasst ferner eine Unterdrucksteuerungsvorrichtung 280. In der in der Fig. 2 dargestellten beispielhaften Dampfphasen-Lötanlage 200 ist diese als ein in vertikaler Richtung verschiebbares kombiniertes Unterdruck- und Überdruckgehäuse 280 ausgebildet. Im Folgenden wird das kombinierte Unterdruck-/Überdruckgehäuse 280 einfach als Druckgehäuse 280 bezeichnet. Es ist jedoch auch möglich, die Unterdrucksteuerungsvorrichtung und die Überdrucksteuerungsvorrichtung als getrennte Einheiten auszuführen (in den Figuren 2 und 3 nicht dargestellt). Darüber hinaus wird anerkannt, dass sich wesentliche Teile des erläuterten Konzepts ausschließlich mit Hilfe einer Unterdrucksteuerungsvorrichtung 280 realisieren lassen.

Eine Unterdrucksteuerungsvorrichtung 280 ermöglicht es, von dem Umgebungsdruck ausgehend einen vorgegebenen Unterdruck an die zu lötende Baugruppe 250 oder die heiße Baugruppe 275 zu legen und den Unterdruck über einen definierten Druckgradienten zu erreichen. Die Unterdrucksteuerungsvorrichtung kann den vorgegebenen Unterdruck über eine wählbare Zeitdauer aufrechterhalten und danach in kontrollierbarer Weise den Umgebungsdruck wieder herstellen.

Eine Überdrucksteuerungsvorrichtung ermöglicht es vom Umgebungsdruck ausgehend einen vorgegebenen Überdruck an die heiße Baugruppe 275 zu legen und den Überdruck über einen definierten Druckgradienten zu erreichen. Die Überdrucksteuerungsvorrichtung kann den vorgegebenen Überdruck über eine wählbare Zeitdauer aufrechterhalten und danach in kontrollierbarer Weise den Umgebungsdruck wieder herzustellen.

Zur Erwärmung befördert die Transportvorrichtung 270 die zu lötende Baugruppe 250 in der Dampfdecke 220 der Prozessflüssigkeit 215. Beim Eintauchen in die Dampfdecke 220 bildet sich um die zu lötende Baugruppe 250 ein dünner Flüssigkeitsfilm 268 der die Baugruppe 250 vor der oxidierenden Einwirkung des Luftsauerstoffs schützt. Die Liquidustemperatur gängiger bleifreier Lotmaterialien liegt im Bereich von etwa 220 °C bis 240 °C. Die zu lötende Baugruppe 250 wird in der Dampfdecke 220 auf eine Temperatur von vorzugsweise etwa 10 °C über Liquidus erwärmt.

Der in dem Beispiel der Fig. 2 beschriebene Temperaturverlauf eines Lötprozesses bezieht sich auf derzeit übliche Lotpasten für bleifreies Löten. Das erfindungsgemäße Vakuumkonzept ist jedoch weder auf bleifreies Löten noch auf den beispielhaft angegebenen Temperaturverlauf beschränkt. Vielmehr kann das definierte Konzept generell für Lötprozesse eingesetzt werden, bei denen die Bildung von Gaseinschlüssen die Qualität der Lötverbindungen beeinträchtigen kann.

Nachdem sich die Baugruppe 250 über die Liquidustemperatur erwärmt hat, bringt die Transportvorrichtung 270 die heiße Baugruppe 275 in das kombinierten Unterdruck-/Überdruckgehäuse 280. Der Flüssigkeitsfilm 268 um die heiße Baugruppe 275 verdunstet beim Herausheben der heißen Baugruppe 275 aus der Dampfdecke 220, so dass die heiße Baugruppe 275 in trockenem Zustand in das Druckgehäuse 280 gelangt.

Die Fig. 3 zeigt schematisch diese Anordnung. Das Druckgehäuse 280 wird bis in die Nähe der Prozesskammer 210 abgesenkt, um so den Transportweg der heißen Baugruppe 275 von der Prozesskammer 210 in das Druckgehäuse 280 so kurz wie möglich zu halten. Zum Einbringen der Baugruppe 275 in das Druckgehäuse 280 ist die untere Wand 281 des Druckgehäuses 280 beweglich ausgeführt (in der Fig. 3 nicht dargestellt). Auf dem gleichen Wege verlässt die Baugruppe 275 am Ende des bzw. der Druckprozesse das Druckgehäuse 280.

An dem Absaugstutzen 288 des Druckgehäuses 280 ist eine Vakuumpumpe angeschlossen (in der Fig. 3 nicht gezeigt), mit deren Hilfe ein einstellbarer Unterdruck in dem Druckgehäuse 280 erzeugt werden kann. Ein Ventil 290 kann die Vakuumpumpe von dem Druckgehäuse 280 trennen. Ferner ermöglicht das kontrollierte Öffnen des Ventils 290 das evakuierte Druckgehäuse 280 wieder kontrolliert zu belüften. Dabei ist es möglich, Luft in das Druckgehäuse 280 einzulassen oder ein weniger reaktives Gas, wie beispielsweise Stickstoff zum Belüften des Druckgehäuses 280 zu verwenden. Damit kann verhindert werden, dass das flüssige Lotmaterial 130 oder eine andere Komponente der heißen Baugruppe 275 mit dem Sauerstoff der Luft eine Oxidationsreaktion ausführt.

Über den Einlassstutzen 290 kann ein einstellbarer Überdruck in dem Druckgehäuse 280 erzeugt werden. Mit Hilfe des Ventils 292 kann das Druckgehäuse 280 vom Einlassstutzen 290 getrennt werden. Darüber hinaus hat das Ventil 292 die Funktion den Überdruck im Inneren des Druckgehäuses 280 in kontrollierter Weise abzubauen. Der Überdruck in dem Druckgehäuse 280 kann durch Einpressen von Luft über den Einlassstutzen 290 erzeugt werden. Es ist jedoch auch möglich, ein oder mehrere andere Gase wie beispielsweise Stickstoff zum Aufbauen des Überdrucks zu verwenden.

Das Druckgehäuse 280 weist ferner an der unteren 281 und/oder an der oberen Wand 285 Heizelemente 282 und 284 auf. Bei Bedarf kann damit die heiße Baugruppe 275 geheizt werden, um sicherzustellen, dass während der Unterdruckzyklen das Lotmaterial 130 der heißen Baugruppe 275 in flüssiger Form vorliegt. Die Heizelemente 282 und 284 können beispielsweise in Form von IR (infrarot) Strahlern ausgeführt werden.

Ein Temperatursensor 286, der an einer Stirnwand des Gehäuses 280 angebracht sein kann, ermöglicht die Kontrolle der Temperatur der heißen Baugruppe 275. Der Temperatursensor 286 erlaubt es eine Regelung der Temperatur in dem Druckgehäuse 280 aufzubauen.

Um anderseits die Temperatur der Baugruppe 275 während eines Überdruckzyklus kontrolliert absenken zu können, kann das Druckgehäuse 280 ferner eine Kühleinrichtung umfassen (in der Fig. 3 nicht dargestellt). Die Kühleinrichtung kann zum Beispiel Flüssigkeiten und/oder Gase als Wärmetransportmedium einsetzen.

Die im Folgenden beschriebenen Konzepte können nicht nur mit der in den Figuren 2 und 3 beispielhaft dargestellten Unterdruck-/Überdrucksteuerungsvorrichtung 280 ausgeführt werden. Vielmehr können diese in verschiedenen Varianten des Druckgehäuses 280 in Dampfphasen-Lötanlagen 200 ausgeführt werden. Insbesondere kann die Anordnung des Druckgehäuses 280 so mit Bewegungsfreiheitsgraden ausgeführt werden, dass die zu lötende Baugruppe 250 zum Ausführen der Unterdruckzyklen nicht bewegt werden muss.

In anderen Reflow-Lötanlagen wie beispielsweise von Konvektions-Reflow-Lötanlagen kann es hingegen günstig sein, das Druckgehäuse 280 ortsfest auszuführen und eine Transportvorrichtung für das Befördern einer zu lötenden Baugruppe 250 von der Wärmequelle zu dem Druckgehäuse 280 vorzusehen.

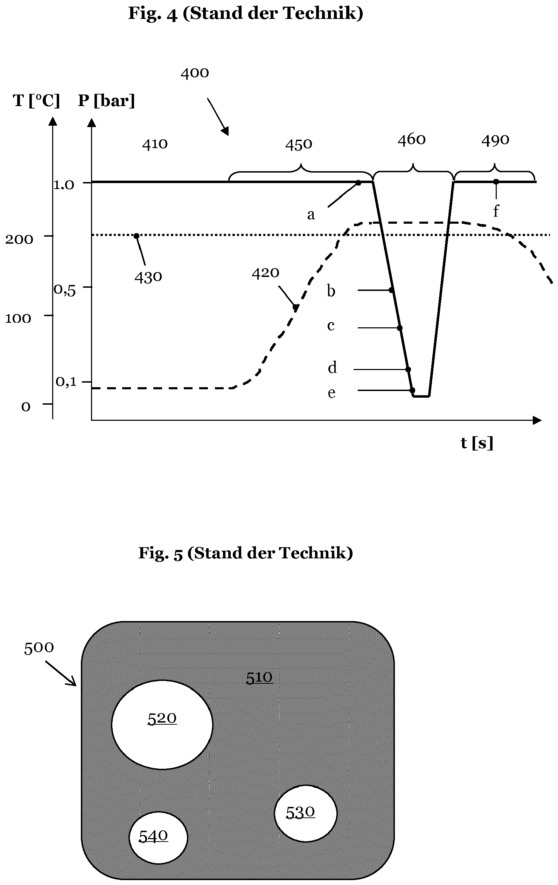

Das Diagramm 400 der Fig. 4 veranschaulicht den Temperaturverlauf 420 der zu lötenden Baugruppe 250 während eines Lötprozesses. Ferner ist in dem Diagramm 400 der Druckverlauf 410 eines Vakuumschritts eingezeichnet, wie er gemäß dem Stand der Technik ausgeführt wird. Während eines Zeitintervalls 450 wird die zu lötende Baugruppe 250 von etwa der Umgebungstemperatur ausgehend auf eine Temperatur erwärmt, bei der das Lotmaterial oder die Lotpaste 130 flüssig ist, d.h. die oberhalb der Liquidustemperatur 430 liegt. Der erlaubte Gradient des Temperaturanstiegs wird von den Herstellern der Bauelemente 260 vorgegeben und liegt im Bereich von 1 °C/s bis zu maximal einigen °C/s. Aus dem Temperaturgradienten bestimmt sich die Zeitdauer der Erwärmungsphase 450.

Während des Erwärmungsvorgangs verdampfen die Lösemittelbestandteile aus der Lotpaste 130. Das in der Lotpaste 130 enthaltene Flussmittel wird durch die erhöhten Temperaturen aktiviert und entfernt durch eine chemische Reaktion Oxidschichten der Metallisierung 120 bzw. von Lötpads und/oder von den Lötanschlüssen der Bauelemente 260. Darüber hinaus reduziert das Flussmittel die Oxide, die durch den Luftsauerstoff bei den erhöhten Temperaturen des Lötprozesses gebildet werden. Bei der in den Figuren 2 und 3 schematisch dargestellten Dampfphasen-Lötanlage 200 tritt die zuletzt genannte Oxidbildung durch den Luftsauerstoff im Wesentlichen nicht auf, da ein dünner Flüssigkeitsfilm 268 das Lotmaterial oder die Lotpaste 130 von dem Einwirken des Sauerstoffs der Luft schützt. An dieser Stelle wie auch an den anderen Stellen dieser Beschreibung bezeichnet der Ausdruck "im Wesentlichen" eine Änderung einer Größe unterhalb deren experimentellen Nachweisgrenze.

Die durch die Wirkung des Flussmittels initiierten chemischen Reaktionen sowie das Entweichen der flüchtigen Bestandteile der Lotpaste 130 bei den höher werdenden Temperaturen der Aufheizphase 450 stellen Gasquellen dar, die neben dem bereits vorhanden Gasvolumen 180 zu Gaseinschlüssen in der Lotpaste 130 über der Liquidustemperatur 430 führen.

Diese Gaseinschlüsse 520, 530, 540 sind schematisch in dem Lotmaterial 510 der Fig. 5 dargestellt. Beim Erstarren des Lotmaterials 130, 510 in dem Zeitbereich 490, in dem die Temperatur des Lotmaterials 130, 510 unter die Liquidustemperatur 430 absinkt, werden die Gaseinschlüsse 520, 530, 540 als Fehlstellen oder Lunker in die gebildete Lötverbindung eingeschlossen. Die so gebildete Lötverbindung weist einen höheren elektrischen und thermischen Widerstand auf, da ein signifikanter Flächenanteil der erzeugten Lötverbindung keinen Beitrag zur Leitung des elektrischen Stroms und des Wärmestroms von dem Bauelement 100, 260 auf die Metallisierung 120 der Keramik 110 oder auf die Lötpads der Leiterplatte 255 liefert.

Um den Anteil der Gaseinschlüsse 520, 530, 540 in der erzeugten Lötverbindung zu verringern, wird in dem Zeitbereich 460 der Fig. 4 ein Vakuumschritt durchgeführt. Dazu wird das über Liquidus erwärmte, flüssige Lotmaterial 510 einem definierten Unterdruck ausgesetzt.

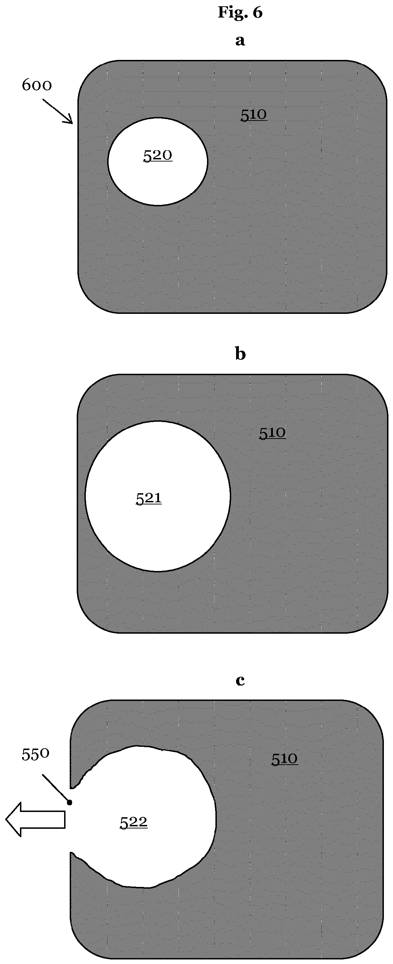

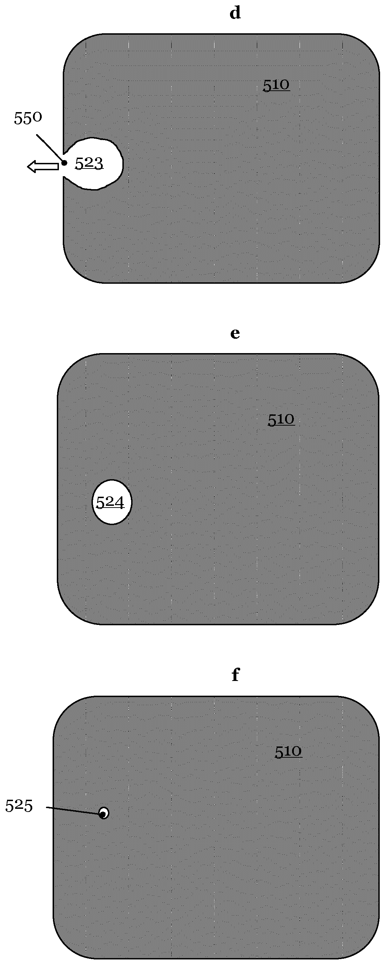

Die Diagramme 600 der Fig. 6 zeigen schematisch die Wirkung eines Unterdrucks auf den größten Gaseinschluss 520 des Lotmaterials 510 der Fig. 5. Im Ausgangszustand a, d.h. nach dem Überschreiten der Liquidustemperatur am Ende der Phase 450 weist der Gaseinschluss 520 die in Fig. 6a dargestellte Größe auf, die im Wesentlichen mit der in der Fig. 5 angegebenen Fläche übereinstimmt. Auf das Verringern des Umgebungsdrucks reagiert der Gaseinschluss 521 mit einer Volumenvergrößerung, um so seinen Innendruck dem reduzierten Umgebungsdruck anzugleichen. Dieser Zusammenhang ist in dem Teilbild b der Fig. 6 illustriert.

Bei einem bestimmten Unterdruck wird das Volumen des Gaseinschlusses 522 so groß, dass er eine freie Oberfläche des flüssigen Lotmaterials 510 erreicht und sich ein Entlüftungskanal 550 des Gaseinschlusses 522 mit der Umgebung bildet. Das Teilbild 6c und der Buchstabe c in dem Druckverlauf der Fig. 4 veranschaulichen diese Situation. Dabei bezeichnet eine freie Oberfläche des Lotmaterials 510 eine Oberfläche, die das Lotmaterial 510 mit der Umgebung bildet.

Einer weiteren Reduzierung des Umgebungsdrucks folgt der Gaseinschluss 523mit einer entsprechenden Volumenverkleinerung. Diese Zusammenhänge werden durch das Teilbild 6d und durch den Buchstaben d in der Fig. 4 symbolisiert.

Unter den in den Teilfiguren 6c und 6d dargestellten Bedingungen wirken zwei gegenläufige Kräfte. Die Druckdifferenz zwischen der Umgebung und dem Inneren der Gaseinschlüsse 522, 523 saugt Gas aus den Einschlüssen 522, 523 ab und hält dadurch den Entlüftungskanal 550 offen. Die Oberflächenspannung des Lotmaterials 510 versucht andererseits durch das Schließen des Entlüftungskanals 550 die Oberfläche des Lotmaterials 510 zu minimieren.

Bei einem bestimmten Unterdruck wird der Druckgradient zwischen Gaseinschluss 524 und dem Umgebungsdruck so gering, dass er nicht mehr ausreicht, den Entlüftungskanal 550 des Gaseinschlusses 524 offen zu halten. Die Oberflächenspannung schließt den Entlüftungskanal 550 und schneidet der Gaseinschluss 524 damit wieder von der Umgebung ab. Diese Zusammenhänge sind schematisch in dem Teilbild 6e und dem Buchstaben e des Druckverlaufs 410 der Fig. 4 dargestellt. Der Unterdruck, bei dem dieser Übergang stattfindet, hängt von der Zusammensetzung des verwendeten Lotmaterials 510 sowie den Materialzusammensetzungen der Lötanschlüsse der Bauelemente 260 der Lötpads der Leiterplatte 255 ab.

Eine weitere Verringerung des Umgebungsdrucks über das mit e in der Fig. 4 gekennzeichnete Niveau hinaus verringert das Volumen des Gaseinschlusses 524 nicht weiter. Ein Aufrechterhalten des Unterdrucks auf dem durch den Buchstaben e angegebenen Level hat ebenfalls keine Auswirkung auf das verbliebene Gasvolumen 524.

Beim Entfernen des Unterdrucks führt der Druckanstieg in der Umgebung des Lotmaterials 510 zu einer Komprimierung des beim Schließen des Entlüftungskanals 550 verbliebenen Gasvolumens 524 auf das in dem Teilbild 6f angegebene Volumen 525.

Der Druckgradient mit dem der Unterdruck erzeugt werden kann, hängt unter anderem entscheidend von der Ausgestaltung des Druckgehäuses 280, des Auslassstutzens 288 sowie der Vakuumpumpe ab. Die Zahlenwerte für die in den Figuren 2 und 3 dargestellte Unterdrucksteuerungsvorrichtung 280 liegen im Bereich von 100 mbar/s, so dass der niedrigste Wert des Drucks nach etwa 10 s erreicht wird.

Aus den oben angegebenen Gründen ist es günstig, das Druckminimum nur für eine kurze Zeitspanne, etwa einige Sekunden, beizubehalten und danach das Druckgehäuse 280 mit Hilfe des Ventils 290 kontrolliert zu belüften. Dabei kann, falls es für nachfolgende Bearbeitungsschritte günstig oder erforderlich ist, das Druckgehäuse 280 mit einem inerten Gas wie etwa Stickstoff geflutet werden, um Oberflächen der Baugruppe 275 für folgende Bearbeitungsschritte vorzubereiten. Für das Ausführen des definierten Vakuumkonzepts ist der Einsatz eines inerten Gases jedoch nicht notwendig.

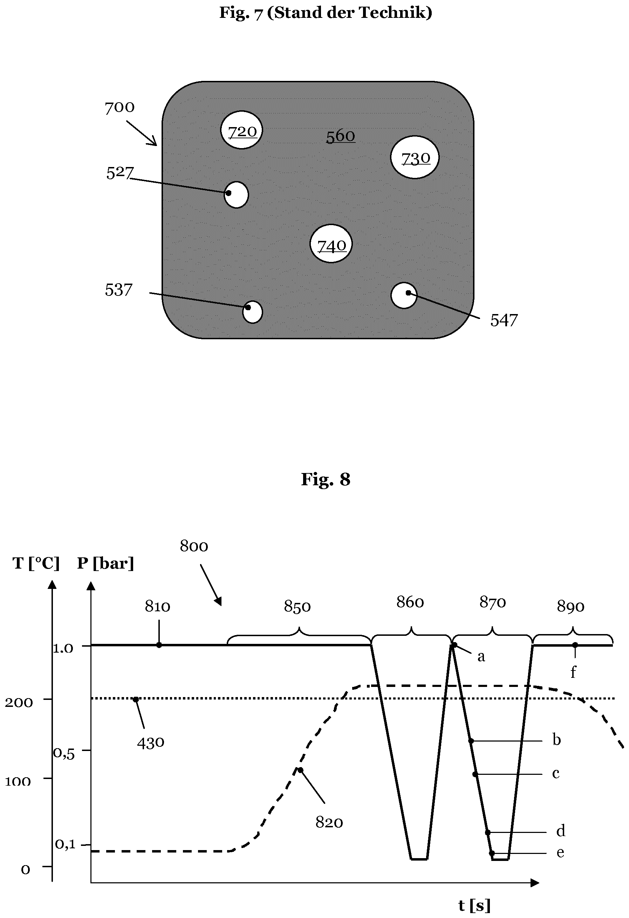

Die Dauer des in der Fig. 4 dargestellten Unterdruckzyklus 460 liegt im Bereich von 20 s. In dem Zeitbereich 490, der sich an den Zeitraum des Unterdruckzyklus 460 anschließt, sinkt die Temperatur der Baugruppe 270 unterhalb die Liquidustemperatur 430 ab und das Lotmaterial 560 erstarrt. Das Diagramm 700 der Fig. 7 zeigt schematisch die Gaseinschlüsse 520, 530, 540 nach der Durchführung des Vakuumschritts 460 beim Erstarren des Lotmaterials 510. In der Lötverbindung 560 sind die Gaseinschlüsse 527, 537, 547 durch den Unterdruckzyklus 460 deutlich verkleinert worden.

Die Lötverbindung 560 der Fig. 7 zeigt jedoch zwei Besonderheiten. Zum einen ist die Volumenreduktion der ursprünglichen Gaseinschlüsse 520, 530, 540 geringer als es die in der Fig. 6 veranschaulichte Entwicklung des Gaseinschlusses 520 erwarten ließ. Zum anderen sind in der Lötverbindung Lunker 720, 730, 740 vorhanden, die zum Zeitpunkt a des Druckverlaufs, d.h. vor dem Unterdruckprozess 460 nicht existierten.

Der in den Figuren 4 bis 6 beschriebene Lötprozess geht davon aus, dass am Ende des Aufheizvorgangs 450, die Gasproduktion des Lotmaterials 510 im Wesentlichen zum Stillstand kommt, so durch den Vakuumschritt 460 ein Großteil des Volumens der Gaseinschlüsse 520, 530, 540 beseitigt werden kann. Die Gaseinschlüsse 527, 537, 547, 720, 730, 740 der Lötverbindung 560 zeigen jedoch deutlich, dass auch nach dem Erreichen der Liquidustemperatur 430 eine oder mehrere Gasquellen vorhanden sein müssen, die zum einen die trotz Vakuumschritt 460 noch vorhandenen Gaseinschlüsse 527, 537, 547 wieder vergrößern und zum anderen neue Gaseinschlüsse 720, 730, 740 generieren. Wie bereits oben ausgeführt, können die Gaseinschlüsse 527, 537, 547, 720, 730, 740 durch eine weitere Verringerung und/oder durch eine längere Beibehaltung des minimalen Unterdrucks nicht mehr verringert werden.

Mögliche Gasquellen sind die bereits oben beschriebenen Ausgasungen der Leiterplatte 255, der kunststoffhaltigen Gehäuseteile 160 der Bauelemente 260 sowie der darin enthaltenen Vergussmassen 150. Ein weiterer Lieferant von Gaspartikeln ist das Freisetzen von Feuchtigkeit, die in den verschiedenen Komponenten der zu lötenden Baugruppe 250 gespeichert ist und die bei den hohen Temperaturen des Lötprozesses aus diesen Komponenten freigegeben werden.

Das Diagramm 800 der Fig. 8 zeigt schematisch wie der Lunkeranteil der Lötverbindung 560 deutlich gesenkt werden kann. Die gestrichelte Linie 820 gibt den Temperaturverlauf an, dem die zulötende Baugruppe 250 unterworfen wird. Wie in der Fig. 4 repräsentiert die punktierte Linie 430 die Liquidustemperatur des Lötmaterials 510. Die Kurve 810 gibt den Druckverlauf an, den die zu lötende Baugruppe 250 im Laufe des Lötprozesses erfährt.

Nachdem der Aufheizvorgang 850 abgeschlossen ist und die Temperatur des Lotmaterials 510 dessen Liquidustemperatur 430 überschritten hat, weist das Lotmaterial 510, die in der Fig. 5 dargestellten Gaseinschlüsse 520, 530, 540 auf. Wie im Rahmen der Diskussion der Figuren 4 bis 6 beschrieben, wird die heiße Baugruppe 275 in das Druckgehäuse 280 eingebracht und einem ersten Unterdruckzyklus 860 ausgesetzt. Am Ende des ersten Unterdruckzyklus 860 weist das flüssige Lotmaterial 510 die in der Fig. 7 veranschaulichten Gaseinschlüsse 527, 537, 547, 720, 730, 740 auf.

Unmittelbar nach Abschluss des ersten Unterdruckzyklus 860, wird ein zweiter Unterdruckzyklus 870 ausgeführt. Dabei liegt die Temperatur des Lotmaterials 510 noch immer über der Liquidustemperatur 430. Die verschiedenen Phasen des zweiten Unterdruckzyklus 870 sind in der Fig. 8 durch die Buchstaben a bis f gekennzeichnet und deren Charakteristika sind in den Teilbildern a bis f der Fig. 6 angegeben.

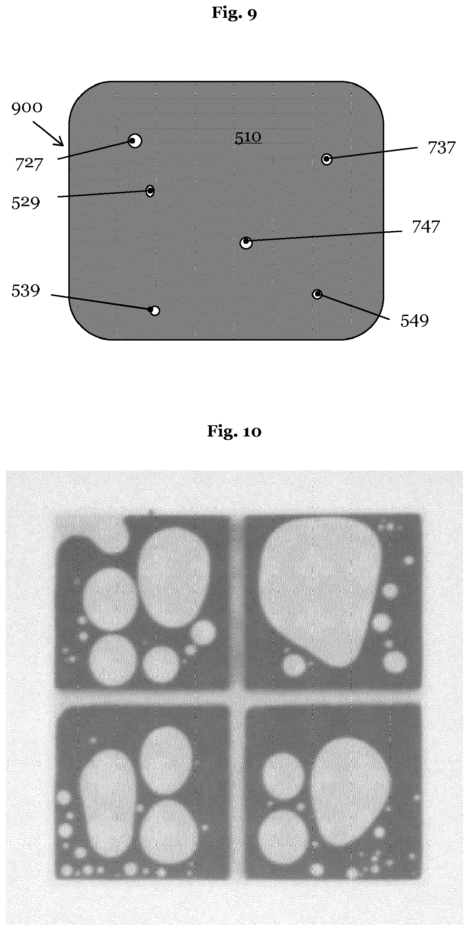

In der Abkühlphase 890 wird beim Erstarren des Lotmaterials 510 zu der Lotverbindung 560 der in der Fig. 9 angegebene Lunkeranteil festgestellt. Der zweite Unterdruckzyklus 870 hat das Volumen der Lunker 529, 539, 549, 727, 737, 747 der Lötverbindung 560 der Fig. 9 im Vergleich zu den in der Fig. 7 dargestellten Gaseinschlüssen 527, 537, 547, 720, 730, 740 des Lotmaterials 510 am Ende des ersten Unterdruckzyklus 870 wesentlich verringert.

Der entscheidende Punkt für die durch den zweiten Unterdruckzyklus 870 bewirkte Verringerung des Lunkeranteils liegt in dem erneuten Ausbilden eines Entlüftungskanals 550 für die am Ende des ersten Unterdruckprozesses 860 noch vorhandenen bzw. wieder vergrößerten 527, 537, 547 und/oder für die in der Zwischenzeit neu gebildeten Gaseinschlüsse 720, 730, 740 während der Druck um das Lotmaterial 510 von dem Umgebungsdruck auf den minimalen Druck abnimmt.

Die Temperatur des Lotmaterials 510 muss bis zum Ende des zweiten Vakuumzyklus 870 oberhalb der Liquidustemperatur 430 gehalten werden.

Die Figuren 10 bis 13 illustrieren die Wirkung eines zweiten Unterdruckprozesses 870 für das Beispiel eines auf eine flexible Leiterplatte gelöteten Bauelements. Diese Figuren zeigen Röntgenbilder einer Lötverbindung, die unter verschiedener Ausführung des Lötprozesses in einer Dampfphasen-Lötanlage 200 hergestellt wurden. Die Fig. 10 präsentiert die Lötstelle eines Lötprozesses, der ohne Vakuumschritt durchgeführt wurde. Der Lunkeranteil der so erzeugten Lötverbindung ist extrem hoch.

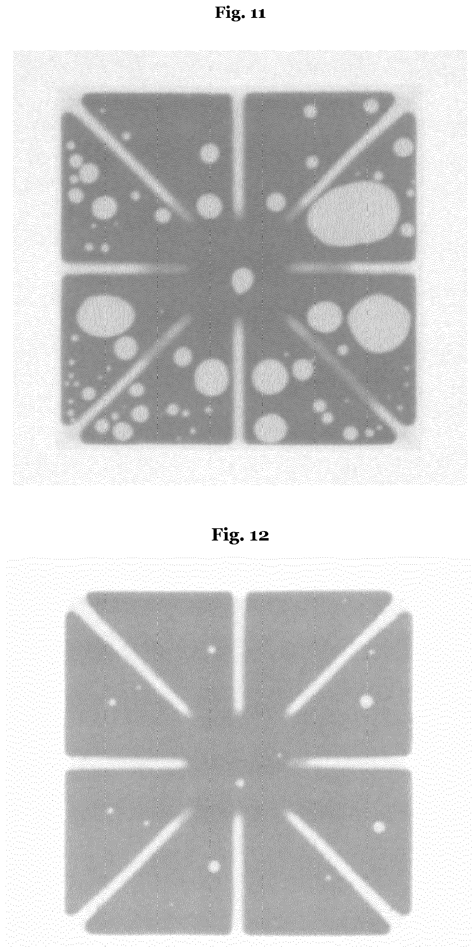

Die Fig. 11 repräsentiert die Lötstelle, die sich ergibt, wenn während des Lötprozesses ein einmaliger Unterdruckprozess 460 durchlaufen wird.

Darüber hinaus wurde die Lötstelle der Fig. 11 mit einer gegenüber der Fig. 10 modifizierten Druckschablone ausgeführt. In die Druckschablone der Fig. 11 wurden zusätzliche Stege eingefügt. Der Unterdruckprozess 460 verringert den Flächenanteil der Lunker der Lötstelle der Fig. 11 im Vergleich mit der in der Fig. 10 gezeigten Lötstelle deutlich. Der Lunkeranteil der Fig. 11 ist jedoch für eine Anwendung noch immer außer jeder Diskussion.

Die in der Fig. 12 dargestellte Lötstelle zeigt das Ergebnis eines Lötprozesses, der unter zweimaliger Anwendung eines Unterdruckprozesses 860 und 870 ausgeführt wurde. Die Lötstelle der Fig. 12 weist zwar noch immer einige sichtbare Fehlstellen oder Lunker auf, deren Anteil ist allerdings verglichen mit der in der Fig. 11 dargestellten Situation verschwindend gering. Die Lötstelle der Fig. 12 kann ohne Bedenken für eine Anwendung freigegeben werden.

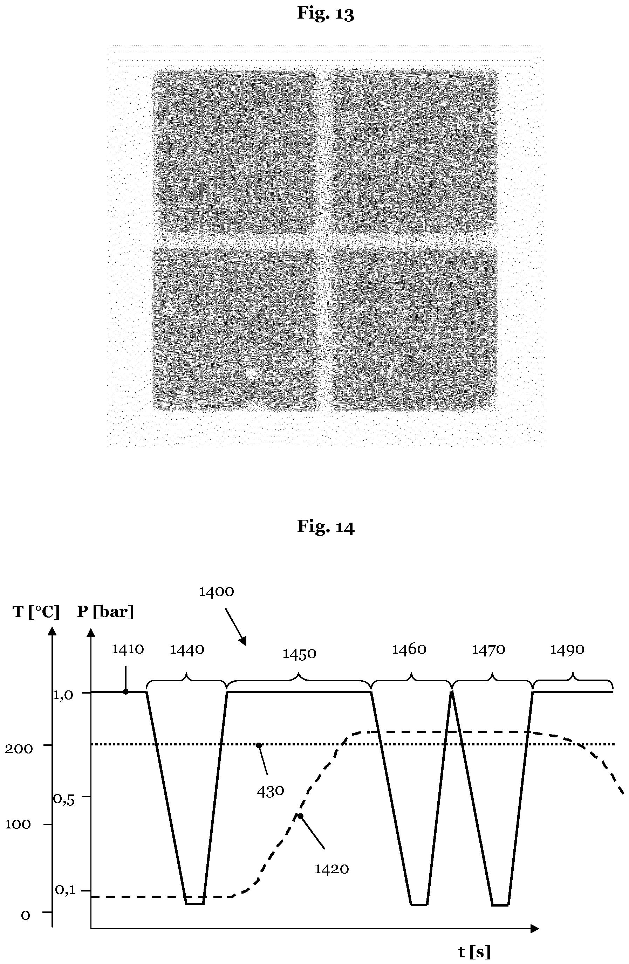

Die Fig. 13 stellt eine Lötstelle dar, für deren Lotpastenauftrag die in der Fig. 10 dargestellte Druckschablone verwendet wurde. Allerdings wurde in dem in der Fig. 13 wiedergegebenen Beispiel das Bauelement nicht auf eine flexible Leiterplatte aufgelötet, sondern auf eine metallisierte Keramik, ähnlich der in der Fig. 1 dargestellten Konfiguration. Während des Lötprozesses wurde ein Vakuumschritt 460 ausgeführt. Der Anteil der Fehlstellen in der in der Fig. 13 erzeugten Lötverbindung ist verschwindend gering.

Der Vergleich der Figuren 10 und 13 liefert die Erklärung für die drastische Wirkung des zweimaligen Unterdruckprozesses 860 und 870 der Fig. 12. Eine Keramik 110 ändert ihre Konsistenz während eines Lötprozesses kaum. Auf der anderen Seite können Leiterplatten 255, insbesondere flexible Leiterplatten hervorgerufen durch die hohen Temperaturen eines Lötprozesses erhebliche Mengen an Gasen freisetzen. Die Ursache der in den Figuren 10 bis 12 manifestierten Ausgasungen können verschiedene chemische Trocknungsprozesse sein, wie zum Beispiel das Endvernetzen von Schutzlacken und Folienklebern. Die damit einhergehende Gasfreisetzung stoppt nicht beim Überschreiten der Liquidustemperatur 430 des Lotmaterials 510, sondern geht angetriebenen durch die hohe Temperatur des Lötprozesses weiter bis die flexible Folie ihre endgültige Konsistenz erreicht. Ein zweiter Unterdruckzyklus kann somit zumindest einen weiteren Teil des Volumens, der durch die Gasfreisetzung wieder vergrößerten 527, 537, 547 und/oder neu gebildeter Gaseinschlüsse 720, 730, 740 entfernen.

Wie bereits oben ausgeführt, können feste Leiterplatten 255, kunststoffhaltige Bauelementgehäuse 160 und/oder Vergussmassen 150 bei den erhöhten Temperaturen des Lötprozesses ebenfalls Gasmengen erheblichen Ausmaßes freisetzen.

Der in der Fig. 8 angegebene Druckverlauf 810 mit zwei Unterdruckzyklen 860 und 870 ist nicht auf die Anwendung in einer Dampfphasen-Lötanlage 200 beschränkt. Vielmehr kann er zur Verringerung des Fehlstellenanteils der Lötverbindungen der meisten Reflow-Lötanlagen wie beispielsweise von Konvektions-Reflow-Lötanlagen oder von IR-Lötanlagen eingesetzt werden.

Das Diagramm 1400 der Fig. 14 zeigt einen Druckverlauf 1410 während eines Lötprozesses bei dem ein zweimaliger Unterdruckzyklus 1460, 1470 mit einem weiteren Unterdruckprozess 1440 vor Beginn des Lötprozesses kombiniert ist. Der Temperaturverlauf 1420 während des Lötprozesses entspricht dem in der Fig. 8 dargestellten Verlauf 820. Die Liquidustemperatur 430 ist in den Figuren 4, 8 und 14 gleich.

Der erste Unterdruckprozess 1440 wird in dem in der Fig. 14 dargestellten Beispiel vor Beginn der Aufheizphase 1450 durchgeführt. Er kann auch zu Teilen oder vollständig während der Aufheizphase 1450 ausgeführt werden. Der Vakuumschritt 1440 saugt vor Beginn des Lötprozesses einen Teil des Lösemittels des Lotmaterials 130, 510 sowie dessen flüchtige Bestandteile des Flussmittels ab. Darüber hinaus erhöht ein Unterdruck - ähnlich wie oben im Kontext der hohen Temperaturen des Lötprozesses beschrieben - mögliche Ausgasungen der Leiterplatte 255, der Bauelementgehäuse 160 und/oder der Vergussmassen 150. Indem zumindest ein Teil des potentiellen Gasreservoirs für eine spätere Lunkerbildung vor dem Lötprozess entfernt wird, wird das zum Bilden von Gaseinschlüssen während des Lötprozesses zur Verfügung stehende Volumen deutlich verringert.

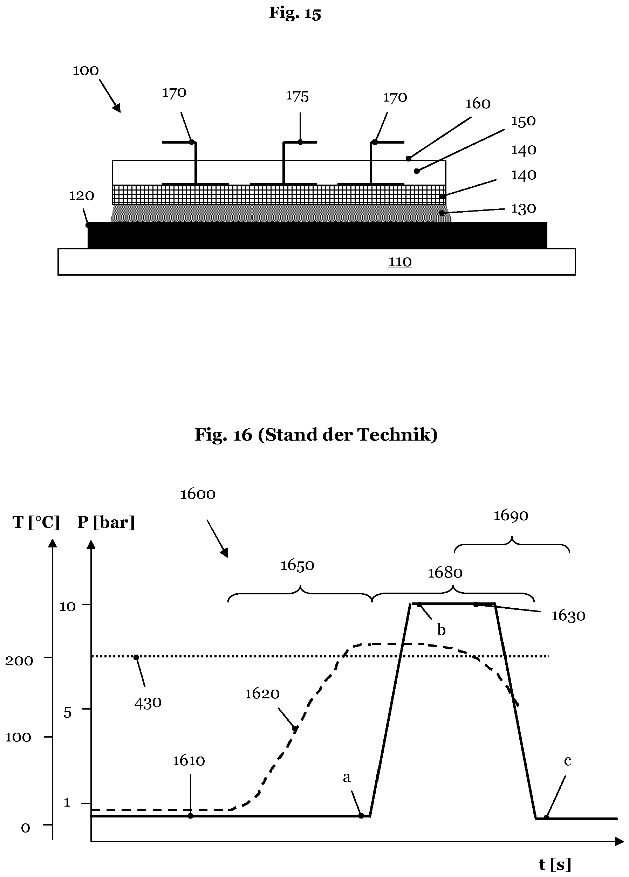

Wie in der Fig. 15 schematisch dargestellt, entfernt der erste Vakuumschritt 1440 zumindest einen Teil des zwischen dem Bauelement 100 und dem Lotpastenauftrag 130 eingeschlossenen Gasvolumens 180 der Fig. 1.

Der erste Vakuumschritt 1440 kann somit auch alleine, d.h. ohne die zweifachen Unterdruckprozesse 1460 und 1470 zur Verbesserung der Qualität der Lötverbindungen 560 von Dampfphasen-Lötanlagen 200 eingesetzt werden. Ferner ist es möglich, den in der Fig. 14 dargestellten ersten Vakuumschritt 1440 für alle anderen Typen von Reflow-Lötanlagen zur Qualitätssteigerung der damit erzeugten Lötverbindungen einzusetzen.

Falls das Druckgehäuse 280, wie in der Fig. 14 gezeigt, auch oder sogar vorwiegend für den Vakuumschritt 1440 eingesetzt wird, ist es günstig, wenn das Druckgehäuse 280 zusätzlich zumindest eine Plasmaquelle enthält, mit deren Hilfe eine zu lötende Baugruppe 250 vor dem Lötprozess gereinigt werden kann. Das Anlegen eines nachfolgenden Unterdrucks entfernt die durch die Einwirkung des Plasmas von der zu lötenden Baugruppe 250 freigesetzten Schmutzpartikel. In dem Druckgehäuse der Figuren 2 und 3 ist die Plasmaquelle nicht dargestellt.

Die Vorteile des Ausführens eines Vakuumschritts 1440 vor dem eigentlichen Lötprozess, die oben im Detail diskutiert wurden, können unabhängig von der Ausführung des nachfolgenden Lötprozesses realisiert werden. Damit steigert das Ausführen eines Vakuumschritts 1440 nicht nur die Qualität von Lötverbindungen 560, die mit Reflow-Lötanlagen hergestellt werden. Mit einem Vakuumschritt 1440 können somit auch Lötstellen verbessert werden, die beispielsweise in Wellen-Lötanlagen oder Selektiv-Lötanlagen erzeugt werden.

Das Diagramm 1600 der Fig. 16 gibt schematisch den Druckverlauf 1610 eines Lötprozesses wieder, in dessen Verlauf ein Unterdruckzyklus 1680 durchgeführt wird. Der Temperaturverlauf 1620 entspricht dem in der Fig. 4 dargestellten Temperaturverlauf. Wiederum ähnlich zum Temperaturverlauf 420 der Fig. 4 erfolgt in der Zeitspanne 1650 das Erwärmen einer zu lötenden Baugruppe 250 auf eine Temperatur oberhalb der Liquidustemperatur 430 des Lotmaterials 510. Nachdem die zu lötende Baugruppe 250 die vorgegebene Temperatur erreicht hat, wird die heiße Baugruppe 275 in das Druckgehäuse 280 eingebracht.

Druckwerte, die mit dem in den Figuren 2 und 3 dargestellten Druckgehäuse 280 erreicht werden können, liegen im Bereich einiger Bar. Der erreichbare Druckanstiegsgradient wird zum überwiegenden Teil von dem verwendeten Kompressor bestimmt. Mit dem in den Figuren 2 und 3 angegebenen Druckgehäuse 280 werden Anstiegsgradienten von etwa 0,5 bar/s erreicht.

Bevorzugt wird Luft als Gas zum Erzeugen eines Überdrucks in dem Druckgehäuse 280 verwendet. Bei Bedarf eines reaktionsträgen Gases kann Stickstoff benutzt werden oder eine Gasmischung deren wesentlicher Bestandteil beispielsweise Stickstoff ausmacht.

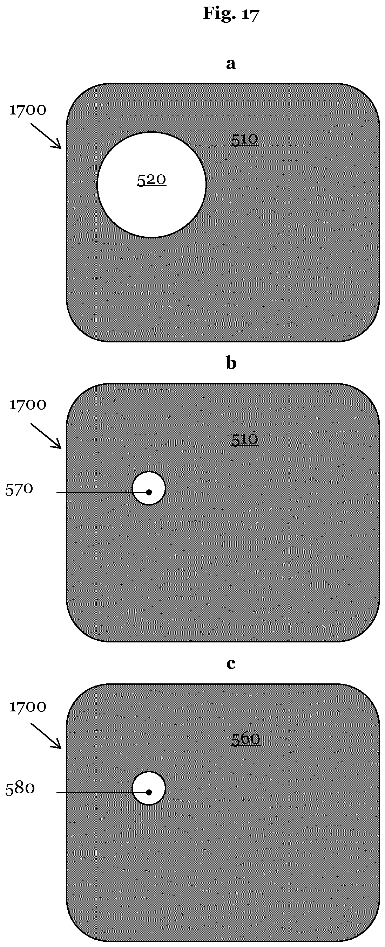

Die Fig. 17a zeigt das Volumen des Gaseinschlusses 520 der Fig. 5 vor dem Anlegen des Unterdrucks. In der Fig. 16 ist diese Ausgangsituation durch den Buchstaben a auf der Druckkurve 1610 veranschaulicht. Über den Einlassstutzen 290 des Druckgehäuses 280 wird nun die heiße Baugruppe 275 einem definierten Überdruck 1630 ausgesetzt. Wie in dem Teilbild b der Fig. 16 gezeigt, komprimiert der Überdruck 1630 den Gaseinschluss 520 auf das Volumen 570. Der Überdruck 1630 wird solange aufrechterhalten, bis das Lotmaterial 510 die Liquidustemperatur 430 unterschritten hat. Beim Erstarren des Lotmaterials 510 zu der Lötverbindung 560 während der Abkühlphase 1690 wird, wie in der Fig. 17c illustriert, der Gaseinschluss 520 mit dem Volumen 570 als Lunker 580 in die Lötverbindung 560 eingeschlossen. Die Fig. 16 gekennzeichnet diese Situation durch den Buchstaben c auf der Druckkurve 1620.

Um den Abkühlprozess der heißen Baugruppe 275 in dem Druckgehäuse 280 zu beschleunigen, weist das Druckgehäuse 280, wie in dem Kontext der Diskussion der Fig. 3 erläutert, eine Kühleinrichtung auf.

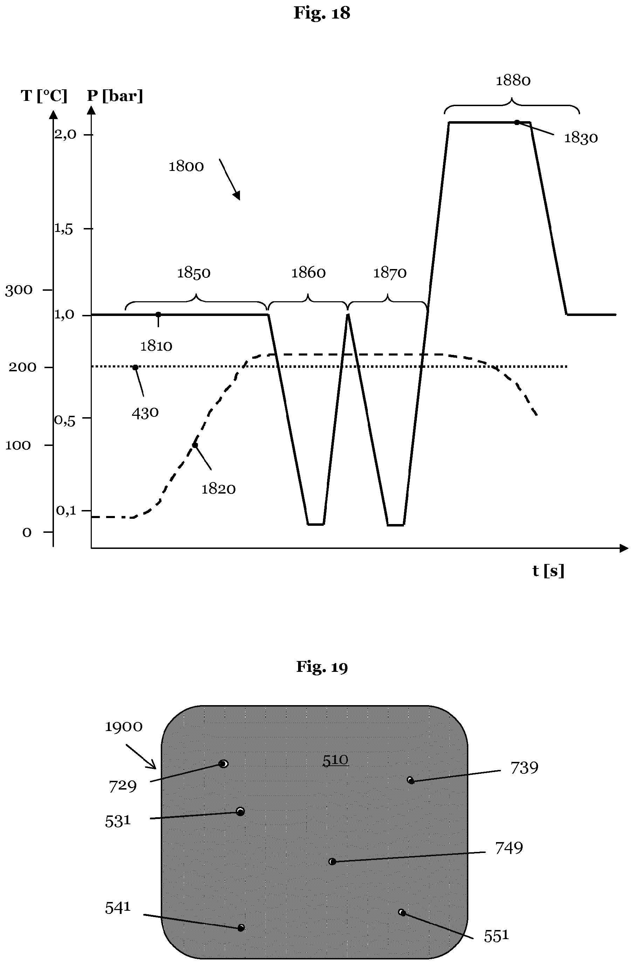

Die Fig. 18 zeigt den Temperaturverlauf 1820 und den Druckverlauf 1810 eines Lötprozesses bei dem zwei Unterdruckzyklen 1860 und 1870 mit einem anschließenden Überdruckzyklus 1880 kombiniert sind. Nach einer Aufheizphase 1850 in der Dampfdecke 220 einer Dampfphasen-Lötanlage 200 in der die zu lötende Baugruppe 250 über die Liquidustemperatur 430 erwärmt wird, wird die heiße Baugruppe 275 in das Überdruckgehäuse 280 eingebracht. Zu diesem Zeitpunkt sind in dem flüssigen Lotmaterial 510 die in der Fig. 5 angegebenen Gaseinschlüsse 520, 530, 540 vorhanden.

In dem Druckgehäuse 280 wird die heiße Baugruppe 275 einem ersten Unterdruckzyklus 1860 unterworfen. Am Ende des ersten Vakuumschritts 1860 weist das Lotmaterial 510, wie in der Fig. 7 dargestellt, die verkleinerten Gaseinschlüsse 527, 537, 547 und die neu entstandenen Gasblasen 720, 730, 740 auf.

Der unmittelbar folgende zweite Unterdruckzyklus 1870 verringert die Volumina der Gaseinschlüsse der Fig. 7 auf die in der Fig. 9 angegebenen Gasblasen 529, 539, 549, 727, 737, 747.

Wie die Fig. 18 zeigt, folgt auf den zweiten Unterdruck 1870 unmittelbar das Anlegen eines Überdrucks an die heiße Baugruppe 275. Dabei muss das Lotmaterial 510 der Baugruppe 275 bis zum Erreichen des maximalen Drucks 1830 oberhalb der Liquidustemperatur bleiben und danach möglichst schnell zu der Lötverbindung 560 erstarren. Um die Zeitdauer des Überdruckprozesses 1880 zu begrenzen, kann die Baugruppe 270 mit der Kühleinrichtung des Druckgehäuses 280 aktiv gekühlt werden. Da das Lotmaterial 510 der heißen Baugruppe 275 nur bis zum Erreichen des maximalen Drucks 1830 flüssig sein muss, vergrößert der Überdruckzyklus 1880 die thermische Belastung der Komponenten der zu lötenden Baugruppe 250, verglichen mit dem Lötprozess der zwei Unterdruckzyklen 860 und 870 verwendet, nur unwesentlich.

Wie oben beschrieben, liegt die Zeit über Liquidus bei dem in der Fig. 8 beschriebenen Lötprozess mit zwei Unterdruckzyklen 860 und 870 im Bereich von 30 s bis 35 s.

Die Fig. 19 illustriert schließlich, dass der Überdruckprozess 1880, die Volumina der Gaseinschlüsse 529, 539, 549, 727, 737, 747 der Fig. 9 auf die nochmals verringerten Volumina 531, 541, 551, 729, 739, 749 komprimiert.

Obwohl die Druckprozesse der Fig. 18 in dem Kontext einer Dampfphasen-Lötanlage 200 diskutiert wurden, ist das Ausführen zweier Unterdruckzyklen 1860 und 1870 gefolgt von einem Überdruckprozess 1880 nicht auf die Anwendung in Dampfphasen-Lötanlagen beschränkt. Vielmehr kann diese Drucksequenz auch in anderen Reflow-Lötanlagen einsetzt werden, wie beispielsweise in Konvektions-Reflow-Lötanlagen oder IR-Lötanlagen.

Ferner kann die in der Fig. 18 dargestellte Drucksequenz um den Unterdruckzyklus 1440 der Fig. 14 erweitert werden. Darüber hinaus ist des ferner möglich, die Druckverläufe der Figuren 4, 8, 14 und 16 in Abhängigkeit der zu lötenden Baugruppe 250 in verschiedenen Kombination in Reflow-Lötanlagen und insbesondere in Dampfphasen-Lötanlagen auszuführen.

### Im Folgenden werden weitere Ausführungsbeispiele beschrieben, um das Verständnis der Erfindung zu erleichtern.

1. Vorrichtung zum Reflow-Löten aufweisend:
   a. zumindest eine Wärmequelle, die ausgebildet ist, um ein Lotmaterial zumindest bis auf eine Liquidustemperatur zu erwärmen; und
   b. zumindest eine Unterdrucksteuerungsvorrichtung, die ausgebildet ist, um zumindest zweimal einen Unterdruck um das Lotmaterial während eines Zeitintervalls zu erzeugen, in der das Lotmaterial eine Temperatur aufweist, die größer oder gleich der Liquidustemperatur ist.
2. Vorrichtung nach Beispiel 1, wobei die Unterdrucksteuerungsvorrichtung ferner ausgebildet ist, den Unterdruck zumindest zweimal im Wesentlichen ohne zeitlichen Abstand zu erzeugen.
3. Vorrichtung nach Beispiel 1 oder 2, wobei die Unterdrucksteuerungsvorrichtung ferner ausgebildet ist, zumindest einen weiteren Unterdruck vor Erreichen der Liquidustemperatur zu erzeugen.
4. Vorrichtung nach einem der vorhergehenden Beispiele, wobei die Unterdrucksteuerungsvorrichtung ausgebildet ist, einen Druck im Bereich von 0,1 mbar bis 500 mbar, bevorzugt von 1 mbar bis 100 mbar und am meisten bevorzugt von 2 mbar bis 50 mbar zu erzeugen und/oder wobei die Unterdrucksteuerungsvorrichtung ausgebildet ist, den erzeugten Druck über einen Zeitraum von 1 ms bis 50 s, bevorzugt von 10 ms bis 10 s und am meisten bevorzugt von 100 ms bis 5 s zu halten und/oder wobei die Unterdrucksteuerungsvorrichtung ferner ausgebildet ist, eine Druckabnahme im Bereich von 10 mbar/s bis 1000 mbar/s, bevorzugt von 20 mbar/s bis 500 mbar/s und am meisten bevorzugt von 50 mbar/s bis 200 mbar/s zu erzeugen.
5. Vorrichtung nach einem der vorhergehenden Beispiele, ferner aufweisend zumindest eine Überdrucksteuerungsvorrichtung, die ausgebildet ist, um zumindest einen Überdruck um das Lotmaterial während eines Zeitintervalls zu erzeugen, in dem eine Temperatur des Lotmaterials von einer ersten Temperatur, die größer oder gleich der Liquidustemperatur ist, auf eine zweite Temperatur unterhalb der Liquidustemperatur absinkt.
6. Vorrichtung nach Beispiel 5, wobei die Überdrucksteuerungsvorrichtung ausgebildet ist, einen Druck im Bereich von 1,1 bar bis 50 bar, bevorzugt von 1,5 bar bis 10 bar und am meisten bevorzugt von 2 bar bis 5 bar zu erzeugen und/oder wobei die Überdrucksteuerungsvorrichtung ausgebildet ist, den erzeugten Druck über einen Zeitraum von 1 s bis 1000 s, bevorzugt von 5 s bis 200 s und am meisten bevorzugt von 10 s bis 100 s zu halten und/oder wobei die Überdrucksteuerungsvorrichtung ferner ausgebildet ist, einen Druckanstieg im Bereich von 10 mbar/s bis 1000 mbar/s, bevorzugt von 20 mbar/s bis 500 mbar/s und am meisten bevorzugt von 50 mbar/s bis 200 mbar/s zu erzeugen.
7. Vorrichtung nach Beispiel 5 oder 6, ferner aufweisend zumindest eine Kühlvorrichtung, wobei die Kühlvorrichtung ausgebildet ist, die Temperatur des Lotmaterials von der ersten Temperatur auf die zweite Temperatur abzusenken, während die Überdrucksteuerungsvorrichtung den Überdruck um das Lotmaterial erzeugt.
8. Vorrichtung nach einem der Beispiele 5 - 7, wobei die Unterdrucksteuerungsvorrichtung und/oder die Überdrucksteuerungsvorrichtung ferner ausgebildet sind, zumindest ein vorgegebenes Unterdruckprofil bzw. zumindest ein vorgegebenes Überdruckprofil zu erzeugen.
9. Vorrichtung nach einem der vorhergehenden Beispiele, wobei die Vorrichtung zum Reflow-Löten als Konvektions-Reflow-Lötanlage ausgebildet ist.
10. Vorrichtung zum Bügellöten aufweisend:
   a. zumindest eine Wärmequelle, die in mechanischen Kontakt mit einer zulötenden Baugruppe kommt und die ausgebildet ist, um ein Lotmaterial der zu lötenden Baugruppe zumindest bis auf eine Liquidustemperatur zu erwärmen; und
   b. zumindest eine Unterdrucksteuerungsvorrichtung, die ausgebildet ist, um zumindest einen Unterdruck während eines Zeitintervalls zu erzeugen, in der die Wärmequelle das Lotmaterial noch nicht bis zumindest auf die Liquidustemperatur erwärmt hat.
11. Vorrichtung nach Beispiel 10, wobei die Unterdrucksteuerungsvorrichtung ausgebildet ist, einen Druck im Bereich von 0,1 mbar bis 500 mbar, bevorzugt von 1 mbar bis 100 mbar und am meisten bevorzugt von 2 mbar bis 50 mbar zu erzeugen und/oder wobei die Unterdrucksteuerungsvorrichtung ausgebildet ist, den erzeugten Druck über einen Zeitraum von 1 ms bis 50 s, bevorzugt von 10 ms bis 10 s und am meisten bevorzugt von 100 ms bis 5 s zu halten und/oder wobei die Unterdrucksteuerungsvorrichtung ferner ausgebildet ist, eine Druckabnahme im Bereich von 10 mbar/s bis 1000 mbar/s, bevorzugt von 20 mbar/s bis 500 mbar/s und am meisten bevorzugt von 50 mbar/s bis 200 mbar/s zu erzeugen.
12. Vorrichtungen zum Wellenlöten oder zum Selektivlöten aufweisend:
   a. zumindest eine Vorrichtung, die ausgebildet ist, um zumindest eine Welle flüssigen Lotmaterials zu erzeugen, die mit zumindest einer zu lötenden Baugruppe in Kontakt kommt; und
   b. zumindest eine Unterdrucksteuerungsvorrichtung, die ausgebildet ist, um zumindest einen Unterdruck um die zumindest eine zu lötende Baugruppe während eines Zeitintervalls zu erzeugen in der die Welle flüssigen Lotmaterials mit der zumindest einen zu lötenden Baugruppe in Kontakt kommt.
13. Vorrichtung nach Beispiel 12, wobei die Unterdrucksteuerungsvorrichtung ausgebildet ist, einen Druck im Bereich von 0,1 mbar bis 500 mbar, bevorzugt von 1 mbar bis 100 mbar und am meisten bevorzugt von 2 mbar bis 50 mbar zu erzeugen.
14. Vorrichtung nach einem der Beispiele 12 oder 13, wobei die Unterdrucksteuerungsvorrichtung ferner ausgebildet ist, zumindest einen weiteren Unterdruck vor Erreichen der Liquidustemperatur zu erzeugen.
15. Verfahren zum Reflow-Löten aufweisend:
   a. Erwärmen eines Lotmaterials zumindest bis auf eine Liquidustemperatur durch zumindest eine Wärmequelle; und
   b. Zweimaliges Erzeugen eines Unterdrucks um das Lotmaterial durch zumindest eine Unterdrucksteuerungsvorrichtung während eines Zeitintervalls in der das Lotmaterial eine Temperatur aufweist, die größer oder gleich der Liquidustemperatur ist.
16. Verfahren nach Beispiel 15, ferner aufweisend zweimaliges Erzeugen des Unterdrucks durch die Unterdrucksteuerungsvorrichtung im Wesentlichen ohne zeitlichen Abstand.
17. Verfahren wie nach einem der Beispiele 15 oder 16, ferner aufweisend Erzeugen eines weiteren Unterdrucks durch die Unterdrucksteuerungsvorrichtung vor Erreichen der Liquidustemperatur.
18. Verfahren nach einem der Beispiele 15 - 17, wobei ein Druck im Bereich von 0,1 mbar bis 500 mbar, bevorzugt von 1 mbar bis 100 mbar und am meisten bevorzugt von 2 mbar bis 50 mbar erzeugt wird und/oder wobei der erzeugte Druck über einen Zeitraum von 1 ms bis 50 s, bevorzugt von 10 ms bis 10 s und am meisten bevorzugt von 100 ms bis 5 s gehalten wird und/oder eine Druckabnahme im Bereich von 10 mbar/s bis 1000 mbar/s, bevorzugt von 20 mbar/s bis 500 mbar/s und am meisten bevorzugt von 50 mbar/s bis 200 mbar/s erzeugt wird.
19. Verfahren nach einem der Beispiele 15 - 18, ferner aufweisend Erzeugen eines Überdrucks um das Lotmaterial durch zumindest eine Überdrucksteuerungsvorrichtung während eines Zeitintervalls, in dem eine Temperatur des Lotmaterials von einer ersten Temperatur, die größer oder gleich der Liquidustemperatur ist, auf eine zweite Temperatur unterhalb der Liquidustemperatur absinkt.
20. Verfahren nach Beispiel 19, wobei ein Druck im Bereich von 1,1 bar bis 50 bar, bevorzugt von 1,5 bar bis 10 bar und am meisten bevorzugt von 2 bar bis 5 bar erzeugt wird und/oder wobei der erzeugte Druck über einen Zeitraum von 1 s bis 1000 s, bevorzugt von 5 s bis 200 s und am meisten bevorzugt von 10 s bis 100 s gehalten wird und/oder wobei ein Druckanstieg im Bereich von 10 mbar/s bis 1000 mbar/s, bevorzugt von 20 mbar/s bis 500 mbar/s und am meisten bevorzugt von 50 mbar/s bis 200 mbar/s erzeugt wird.
21. Verfahren nach Beispiel 19 oder 20, ferner aufweisend Absenken der Temperatur des Lotmaterials von der ersten Temperatur auf die zweite Temperatur durch zumindest eine Kühlvorrichtung während des Erzeugens des Überdrucks um das Lotmaterial durch die Überdrucksteuerungsvorrichtung.
22. Verfahren nach einem der Beispiele 19 - 21, ferner aufweisend Erzeugen zumindest eines vorgegebenen Unterdruckprofils durch die Unterdrucksteuerungsvorrichtung und/oder Erzeugen zumindest eines vorgegebenen Überdruckprofils durch die Überdrucksteuerungsvorrichtung.
23. Verfahren nach einem der Beispiele 15 - 22, wobei das Erwärmen des Lotmaterials und das Ausführen des Unterdrucks in einer Konvektions-Reflow-Lötanlage erfolgen.
24. Verfahren zum Bügellöten aufweisend:
   a. Erwärmen eines Lotmaterials einer zu lötenden Baugruppe durch zumindest eine Wärmequelle zumindest bis auf eine Liquidustemperatur; und
   b. Erzeugen zumindest eines Unterdrucks durch eine Unterdrucksteuerungsvorrichtung während eines Zeitintervalls, in der die Wärmequelle das Lotmaterial noch nicht bis zumindest auf die Liquidustemperatur erwärmt hat.
25. Verfahren nach Beispiel 24, wobei ein Druck im Bereich von 0,1 mbar bis 500 mbar, bevorzugt von 1 mbar bis 100 mbar und am meisten bevorzugt von 2 mbar bis 50 mbar erzeugt wird und/oder wobei der erzeugte Druck über einen Zeitraum von 1 ms bis 50 s, bevorzugt von 10 ms bis 10 s und am meisten bevorzugt von 100 ms bis 5 s gehalten wird und/oder eine Druckabnahme im Bereich von 10 mbar/s bis 1000 mbar/s, bevorzugt von 20 mbar/s bis 500 mbar/s und am meisten bevorzugt von 50 mbar/s bis 200 mbar/s erzeugt wird.
26. Verfahren zum Wellenlöten oder zum Selektivlöten aufweisend:
   a. Erzeugen zumindest einer Welle flüssigen Lotmaterials, die mit zumindest einer zu lötenden Baugruppe in Kontakt kommt durch zumindest eine Vorrichtung; und
   b. Erzeugen zumindest eines Unterdrucks um die zumindest eine zu lötende Baugruppe durch zumindest eine Unterdrucksteuerungsvorrichtung während eines Zeitintervalls in der die Welle flüssigen Lotmaterials mit der zumindest einen zu lötenden Baugruppe in Kontakt kommt.
27. Verfahren nach Beispiel 26, wobei ein Druck im Bereich von 0,1 mbar bis 500 mbar, bevorzugt von 1 mbar bis 100 mbar und am meisten bevorzugt von 2 mbar bis 50 mbar erzeugt wird.
28. Verfahren nach Beispiel 26 oder 27, ferner aufweisend Erzeugen eines weiteren Unterdrucks durch die Unterdrucksteuerungsvorrichtung vor Erreichen der Liquidustemperatur.

## Patentansprüche

1. Vorrichtung zum Reflow-Löten (200, 300) aufweisend:
a. zumindest eine Wärmequelle (225), die ausgebildet ist, um ein Lotmaterial (130, 510) zumindest bis auf eine Liquidustemperatur (430) zu erwärmen; und
b. zumindest eine Unterdrucksteuerungsvorrichtung (280), die ausgebildet ist, um zumindest zweimal einen Unterdruck um das Lotmaterial (130, 510) während eines Zeitintervalls zu erzeugen, in der das Lotmaterial (130, 10) eine Temperatur aufweist, die größer oder gleich der Liquidustemperatur (430) ist.

2. Vorrichtung (200, 300) nach Anspruch 1, wobei die Unterdrucksteuerungsvorrichtung (280) ferner ausgebildet ist, den Unterdruck zumindest zweimal im Wesentlichen ohne zeitlichen Abstand zu erzeugen.

3. Vorrichtung (200, 300) nach Anspruch 1 oder 2, wobei die Unterdrucksteuerungsvorrichtung (280) ferner ausgebildet ist, zumindest einen weiteren Unterdruck vor Erreichen der Liquidustemperatur (430) zu erzeugen.

4. Vorrichtung (200, 300) nach einem der vorhergehenden Ansprüche, wobei die Unterdrucksteuerungsvorrichtung (280) ausgebildet ist, einen Druck im Bereich von 0,1 mbar bis 500 mbar, bevorzugt von 1 mbar bis 100 mbar und am meisten bevorzugt von 2 mbar bis 50 mbar zu erzeugen oder wobei die Unterdrucksteuerungsvorrichtung (280) ausgebildet ist, den erzeugten Druck über einen Zeitraum von 1 ms bis 50 s, bevorzugt von 10 ms bis 10 s und am meisten bevorzugt von 100 ms bis 5 s zu halten oder wobei die Unterdrucksteuerungsvorrichtung (280) ferner ausgebildet ist, eine Druckabnahme im Bereich von 10 mbar/s bis 1000 mbar/s, bevorzugt von 20 mbar/s bis 500 mbar/s und am meisten bevorzugt von 50 mbar/s bis 200 mbar/s zu erzeugen.

5. Vorrichtung (200, 300) nach einem der vorhergehenden Ansprüche, ferner aufweisend zumindest eine Überdrucksteuerungsvorrichtung (280), die ausgebildet ist, um zumindest einen Überdruck um das Lotmaterial (130, 510) während eines Zeitintervalls zu erzeugen, in dem eine Temperatur des Lotmaterials (130, 510) von einer ersten Temperatur, die größer oder gleich der Liquidustemperatur (430) ist, auf eine zweite Temperatur unterhalb der Liquidustemperatur (430) absinkt.

6. Vorrichtung (200, 300) nach Anspruch 5, wobei die Überdrucksteuerungsvorrichtung (280) ausgebildet ist, einen Druck im Bereich von 1,1 bar bis 50 bar, bevorzugt von 1,5 bar bis 10 bar und am meisten bevorzugt von 2 bar bis 5 bar zu erzeugen oder wobei die Überdrucksteuerungsvorrichtung (280) ausgebildet ist, den erzeugten Druck über einen Zeitraum von 1 s bis 1000 s, bevorzugt von 5 s bis 200 s und am meisten bevorzugt von 10 s bis 100 s zu halten oder wobei die Überdrucksteuerungsvorrichtung (280) ferner ausgebildet ist, einen Druckanstieg im Bereich von 10 mbar/s bis 1000 mbar/s, bevorzugt von 20 mbar/s bis 500 mbar/s und am meisten bevorzugt von 50 mbar/s bis 200 mbar/s zu erzeugen.

7. Verfahren zum Reflow-Löten aufweisend:
a. Erwärmen eines Lotmaterials (130, 510) zumindest bis auf eine Liquidustemperatur (430) durch zumindest eine Wärmequelle (225); und
b. Zweimaliges Erzeugen eines Unterdrucks um das Lotmaterial (130, 510) durch zumindest eine Unterdrucksteuerungsvorrichtung (280) während eines Zeitintervalls in der das Lotmaterial (130, 510) eine Temperatur aufweist, die größer oder gleich der Liquidustemperatur (430) ist.

8. Verfahren nach Anspruch 7, ferner aufweisend zweimaliges Erzeugen des Unterdrucks durch die Unterdrucksteuerungsvorrichtung (280) im Wesentlichen ohne zeitlichen Abstand.

9. Verfahren wie nach einem der Ansprüche 7 oder 8, ferner aufweisend Erzeugen eines weiteren Unterdrucks durch die Unterdrucksteuerungsvorrichtung (280) vor Erreichen der Liquidustemperatur (430).

10. Verfahren nach einem der Ansprüche 7 - 9, wobei ein Druck im Bereich von 0,1 mbar bis 500 mbar, bevorzugt von 1 mbar bis 100 mbar und am meisten bevorzugt von 2 mbar bis 50 mbar erzeugt wird oder wobei der erzeugte Druck über einen Zeitraum von 1 ms bis 50 s, bevorzugt von 10 ms bis 10 s und am meisten bevorzugt von 100 ms bis 5 s gehalten wird oder eine Druckabnahme im Bereich von 10 mbar/s bis 1000 mbar/s, bevorzugt von 20 mbar/s bis 500 mbar/s und am meisten bevorzugt von 50 mbar/s bis 200 mbar/s erzeugt wird.

11. Verfahren nach einem der Ansprüche 7 - 10, ferner aufweisend Erzeugen eines Überdrucks um das Lotmaterial (130, 510) durch zumindest eine Überdrucksteuerungsvorrichtung (280) während eines Zeitintervalls, in dem eine Temperatur des Lotmaterials (130, 510) von einer ersten Temperatur, die größer oder gleich der Liquidustemperatur (430) ist, auf eine zweite Temperatur unterhalb der Liquidustemperatur (430) absinkt.

12. Verfahren nach Anspruch 11, wobei ein Druck im Bereich von 1,1 bar bis 50 bar, bevorzugt von 1,5 bar bis 10 bar und am meisten bevorzugt von 2 bar bis 5 bar erzeugt wird oder wobei der erzeugte Druck über einen Zeitraum von 1 s bis 1000 s, bevorzugt von 5 s bis 200 s und am meisten bevorzugt von 10 s bis 100 s gehalten wird oder wobei ein Druckanstieg im Bereich von 10 mbar/s bis 1000 mbar/s, bevorzugt von 20 mbar/s bis 500 mbar/s und am meisten bevorzugt von 50 mbar/s bis 200 mbar/s erzeugt wird.

13. Verfahren nach Anspruch 11 oder 12, ferner aufweisend Absenken der Temperatur des Lotmaterials (130, 510) von der ersten Temperatur auf die zweite Temperatur durch zumindest eine Kühlvorrichtung während des Erzeugens des Überdrucks um das Lotmaterial durch die Überdrucksteuerungsvorrichtung (280).

14. Verfahren nach einem der Ansprüche 11- 13, ferner aufweisend Erzeugen zumindest eines vorgegebenen Unterdruckprofils durch die Unterdrucksteuerungsvorrichtung (280) und/oder Erzeugen zumindest eines vorgegebenen Überdruckprofils durch die Überdrucksteuerungsvorrichtung (280).

15. Verfahren nach einem der Ansprüche 7 - 14, wobei das Erwärmen des Lotmaterials (130, 510) und das Ausführen des Unterdrucks in einer Konvektions-Reflow-Lötanlage erfolgen.

## Claims

1. An apparatus for reflow soldering (200, 300) comprising:
a. at least one heat source (225) configured to heat a solder material (130, 510) at least up to a liquidus temperature (430); and
b. at least one low pressure control device (280) configured to generate at least twice a low pressure around the solder material (130, 510) during a time interval in which the solder material (130, 510) has a temperature greater than or equal to the liquidus temperature (430).

2. The apparatus (200, 300) according to claim 1, wherein the low-pressure control device (280) is further configured to generate the low pressure at least twice essentially without a time gap.

3. The apparatus (200, 300) according to claim 1 or 2, wherein the low-pressure control device (280) it further configured to generate at least a further low-pressure prior to reaching the liquidus temperature (430).

4. The apparatus (200, 300) according to any one of the preceding claims, wherein the low-pressure control device (280) is configured to generate a pressure in a range from 0.1 mbar to 500 mbar, preferred from 1 mbar to 100 mbar, and most preferred from 2 mbar to 50 mbar, or wherein the low-pressure control device (280) is configured to generate the generated pressure over a time period from 1 ms to 50 s, preferred from 10 ms to 10 s, and most preferred from 100 ms to 5 s, or wherein the low-pressure control device (280) is further configured to generate a decrease of pressure in the range from 10 mbar/s to 1000 mbar/s, preferred from 20 mbar/s to 500 mbar/s, and most preferred from 50 mbar/s to 200 mbar/s.

5. The apparatus (200, 300) according to any one of the preceding claims, further comprising at least one excess pressure control device (280) configured to generate at least one excess pressure around the solder material (130, 510) during a time interval in which the temperature of the solder material (130, 510) decreases from a first temperature which is larger than or equal to the liquidus temperature (430) to a second temperature below the liquidus temperature (430).

6. The apparatus (200, 300) according to claim 5, wherein the excess pressure control device (280) is configured to generate a pressure in the range from 1.1 bar to 50 bar, preferred from 1.5 bar to 10 bar and most preferred from 2 bar to 5 bar, or wherein the excess pressure control device (280) is configured to keep the generated pressure across a time interval from 1 s to 1000 s, preferred from 5 s to 200 s, and most preferred from 10 s to 100 s, or wherein the excess pressure control device (280) is further configured to generate a pressure built up in a range from 10 mbar/s to 1000 mbar/s, preferred from 20 mbar/s to 500 mbar/s and most preferred from 50 mbar/s to 200 mbar/s.

7. A method for reflow soldering, comprising:
a. heating a solder material (130, 510) at least up to a liquidus temperature (430) by at least one heat source (225); and
b. generating twice a low-pressure around the solder material (130, 510) by at least one low-pressure control device (280) during a time interval in which the solder material (130, 510) has a temperature which is greater than or equal to the liquidus temperature (430).

8. The method according to claim 7, further comprising: generating twice a low-pressure essentially without a time gap by the low-pressure control device (280).

9. The method according to claim 7 or 8, further comprising: generating a further low-pressure prior to reaching the liquidus temperature (430) by the low-pressure control device (280).

10. The method according to one of the claims 7 to 9, wherein a pressure is generated in a range from 0.1 mbar to 500 mbar, preferred from 1 mbar to 100 mbar, and most preferred from 2 mbar to 50 mbar, or wherein the generated pressure is kept over a time interval from 1 ms to 50 s, preferred from 10 ms to 10 s, and most preferred from 100 ms to 5 s, or wherein a decrease of pressure is generated in a range from 10 mbar/s to 1000 mbar/s, preferred from 20 mbar/s to 500 mbar/s, and most preferred from 50 mbar/s to 200 mbar/s.

11. The method according to claims 7 to 10, further comprising: generating an excess pressure around the solder material (130, 510) by an excess pressure control device (280) during a time period in which a temperature of the solder material (130, 510) decreases from a first temperature which is greater than or equal to the liquidus temperature to a second temperature below the liquidus temperature (430).

12. The method according to claim 11, wherein a pressure is generated in a range from 1.1 bar to 50 bar, preferred from 1.5 bar to 10 bar, and most preferred from 2 bar to 5 bar, or wherein the generated pressure is kept over a time interval from 1 s to 1000 s, preferred from 5 s to 200 s, and most preferred from 10 s to 100 s, or wherein a pressure built-up is generated in a range from 10 mbar/s to 1000 mbar/s, preferred from 20 mbar/s to 500 mbar/s, and most preferred from 50 mbar/s to 200 mbar/s.

13. The method according to claim 11 or 12 further comprising: decreasing the temperature of the solder material (130, 510) from the first temperature to the second temperature by at least one cooling device when generating the excess pressure around the solder material by the excess pressure control device (280).

14. The method according to one of the claims 11 to 13 further comprising:
generating at least a predetermined low pressure profile by the low-pressure control device (280) and/or generating at least a predetermined excess pressure profile by the excess pressure control device (280).

15. The method according to one of the claims 7 to 14, wherein heating the solder material (130, 510) and generating the low pressure occurs in a convection reflow solder machine.

## Revendications

1. Dispositif de brasage par refusion (200, 300) comprenant :
a. au moins une source de chaleur (225) qui est conçue pour chauffer un matériau de brasage (130, 510) au moins jusqu'à une température de liquidus (430) ; et
b. au moins un dispositif de commande de pression négative (280) qui est conçu pour produire au moins deux fois une pression négative autour du matériau de brasage (130, 510) pendant un intervalle de temps dans lequel le matériau de brasage (130, 510) présente une température qui est supérieure ou égale à la température de liquidus (430).

2. Dispositif (200, 300) selon la revendication 1, le dispositif de commande de pression négative (280) étant en outre conçu pour produire la pression négative au moins deux fois sensiblement sans décalage temporel.

3. Dispositif (200, 300) selon la revendication 1 ou 2, le dispositif de commande de pression négative (280) étant en outre conçu pour produire au moins une pression négative supplémentaire avant d'atteindre la température de liquidus (430).

4. Dispositif (200, 300) selon une des revendications précédentes, le dispositif de commande de pression négative (280) étant conçu pour produire une pression dans la plage de 0,1 mbar à 500 mbar, de préférence de 1 mbar à 100 mbar et, le plus préférablement, de 2 mbar à 50 mbar, ou le dispositif de commande de pression négative (280) étant conçu pour maintenir la pression produite pendant une durée de 1 ms à 50 s, de préférence de 10 ms à 10 s et, le plus préférablement, de 100 ms à 5 s, ou le dispositif de commande de pression négative (280) étant en outre conçu pour produire une baisse de pression dans la plage de 10 mbar/s à 1 000 mbar/s, de préférence de 20 mbar/s à 500 mbar/s et, le plus préférablement, de 50 mbar/s à 200 mbar/s.

5. Dispositif (200, 300) selon une des revendications précédentes, comprenant en outre au moins un dispositif de commande de pression positive (280) qui est conçu pour produire au moins une pression positive autour du matériau de brasage (130, 510) pendant un intervalle de temps dans lequel une température du matériau de brasage (130, 510) baisse d'une première température, qui est supérieure ou égale à la température de liquidus (430), à une seconde température inférieure à la température de liquidus (430).

6. Dispositif (200, 300) selon la revendication 5, le dispositif de commande de pression positive (280) étant conçu pour produire une pression dans la plage de 1,1 bar à 50 bar, de préférence de 1,5 bar à 10 bar et, le plus préférablement, de 2 bar à 5 bar, ou le dispositif de commande de pression positive (280) étant conçu pour maintenir la pression produite pendant une durée de 1 s à 1000 s, de préférence de 5 s à 200 s et, le plus préférablement, de 10 s à 100 s, ou le dispositif de commande de pression positive (280) étant en outre conçu pour produire une élévation de pression dans la plage de 10 mbar/s à 1 000 mbar/s, de préférence de 20 mbar/s à 500 mbar/s et, le plus préférablement, de 50 mbar/s à 200 mbar/s.

7. Procédé de brasage par refusion consistant à :
a. chauffer un matériau de brasage (130, 510) au moins à une température de liquidus (430) à l'aide d'au moins une source de chaleur (225) ; et
b. produire deux fois une pression négative autour du matériau de brasage (130, 510) à l'aide d'au moins un dispositif de commande de pression négative (280) pendant un intervalle de temps dans lequel le matériau de brasage (130, 510) présente une température qui est supérieure ou égale à la température de liquidus (430).

8. Procédé selon la revendication 7, consistant en outre à produire deux fois une pression négative à l'aide du dispositif de commande de pression négative (280) sensiblement sans décalage temporel.

9. Procédé conforme à une des revendications 7 ou 8, consistant en outre à produire une pression négative supplémentaire à l'aide du dispositif de commande de pression négative (280) avant d'atteindre la température de liquidus (430).

10. Procédé selon une des revendications 7 à 9, une pression dans la plage de 0,1 mbar à 500 mbar, de préférence de 1 mbar à 100 mbar et, le plus préférablement, de 2 mbar à 50 mbar étant produite, ou la pression produite étant maintenue pendant une durée de 1 ms à 50 s, de préférence de 10 ms à 10 s et, le plus préférablement, de 100 ms à 5 s, ou une baisse de pression étant produite dans la plage de 10 mbar/s à 1 000 mbar/s, de préférence de 20 mbar/s à 500 mbar/s et, le plus préférablement, de 50 mbar/s à 200 mbar/s.

11. Procédé selon une des revendications 7 à 10, consistant en outre à produire une pression positive autour du matériau de brasage (130, 510) à l'aide d'au moins un dispositif de commande de pression positive (280) pendant un intervalle de temps dans lequel une température du matériau de brasage (130, 510) baisse d'une première température, qui est supérieure ou égale à la température de liquidus (430), à une seconde température inférieure à la température de liquidus (430).

12. Dispositif selon la revendication 11, une pression dans la plage de 1,1 bar à 50 bar, de préférence de 1,5 bar à 10 bar et, le plus préférablement, de 2 bar à 5 bar étant produite, ou la pression produite étant maintenue pendant une durée de 1 s à 1 000 s, de préférence de 5 s à 200 s et, le plus préférablement, de 10 s à 100 s, ou une élévation de pression dans la plage de 10 mbar/s à 1 000 mbar/s, de préférence de 20 mbar/s à 500 mbar/s et, le plus préférablement, de 50 mbar/s à 200 mbar/s étant produite.

13. Procédé selon la revendication 11 ou 12, consistant en outre à abaisser la température du matériau de brasage (130, 510) de la première température à la seconde température à l'aide d'au moins un dispositif de refroidissement pendant la production de la pression positive autour du matériau de brasage à l'aide du dispositif de commande de pression positive (280).

14. Procédé selon une des revendications 11 à 13, consistant en outre à produire au moins un profil de pression négative prédéfini à l'aide du dispositif de commande de pression négative (280) et/ou à produire au moins un profil de pression positive prédéfini à l'aide du dispositif de commande de pression positive (280).

15. Procédé selon une des revendications 7 à 14, le chauffage du matériau de brasage (130, 510) et l'instauration de la pression négative s'effectuant dans une installation de brasage par refusion à convection.
